(19) Europäisches Patentamt
European Patent Office
Office européen des brevets

(11) **EP 4 478 610 A1**

(12) **EUROPEAN PATENT APPLICATION**
published in accordance with Art. 153(4) EPC

(43) Date of publication:
**18.12.2024 Bulletin 2024/51**

(21) Application number: **23778533.2**

(22) Date of filing: **03.04.2023**

(51) International Patent Classification (IPC):
**H03H 9/205** (2006.01)    **H03H 9/02** (2006.01)

(52) Cooperative Patent Classification (CPC):
**H03H 9/02; H03H 9/205**

(86) International application number:
**PCT/CN2023/085912**

(87) International publication number:
**WO 2023/186169 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.04.2022   CN 202210347533**
**28.03.2023   CN 202310370697**

(71) Applicant: **Huawei Technologies Co., Ltd.**
**Shenzhen, Guangdong 518129 (CN)**

(72) Inventors:
• **FENG, Zhihong**
  **Shenzhen, Guangdong 518129 (CN)**
• **SUN, Fengpei**
  **Shenzhen, Guangdong 518129 (CN)**
• **XU, Jinghui**
  **Shenzhen, Guangdong 518129 (CN)**
• **HUANG, Linhai**
  **Shenzhen, Guangdong 518129 (CN)**

(74) Representative: **Maiwald GmbH**
**Engineering**
**Elisenhof**
**Elisenstrasse 3**
**80335 München (DE)**

(54)    **RESONATOR AND RESONANT SYSTEM**

(57)    A resonator and a resonant system belong to the field of device technologies. The resonator includes a piezoelectric resonance part, a single crystal resonance part, and a coupling part. The piezoelectric resonance part includes a first electrode, a piezoelectric layer, and a second electrode that are sequentially stacked. When a drive signal is loaded between the first electrode and the second electrode, the piezoelectric resonance part can resonate under an action of the drive signal. A material of the single crystal resonance part is a single crystal material or a doped single crystal material. The piezoelectric resonance part and the single crystal resonance part can resonate, and the piezoelectric resonance part and the single crystal resonance part are connected and coupled through the coupling part. Because the piezoelectric resonance part and the single crystal resonance part can be coupled through the coupling part, the single crystal resonance part is in a vibration direction of the piezoelectric resonance part. This application resolves a problem that performance of a piezoelectric resonator is poor. This application is used for the resonator.

FIG. 4

# Description

This application claims priority to Chinese Patent Application No. 202210347533.1, filed with the China National Intellectual Property Administration on April 1, 2022 and entitled "RESONATOR, RESONANT SYSTEM, AND SIGNAL OBTAINING METHOD", which is incorporated herein by reference in its entirety.

## TECHNICAL FIELD

This application relates to the field of device technologies, and in particular, to a resonator and a resonant system.

## BACKGROUND

A resonator is a device for generating a vibration signal (also referred to as a frequency signal). The resonator may be used in a resonant system, for example, an oscillator or a sensor.

A piezoelectric resonator is a common resonator. The piezoelectric resonator includes a first electrode, a piezoelectric layer, and a second electrode that are sequentially stacked. When a drive signal is loaded on the first electrode and the second electrode, the piezoelectric resonator can resonate under an action of the drive signal, so as to generate a vibration signal.

However, a quality factor (quality factor, Q) of the piezoelectric resonator is low. In addition, during application of a resonator with a high Q value, performance of the piezoelectric resonator is positively correlated with Q of the piezoelectric resonator. As a result, performance of the piezoelectric resonator is poor.

## SUMMARY

This application provides a resonator and a resonant system, to resolve a problem that performance of a piezoelectric resonator is poor. The technical solutions are as follows:

According to a first aspect, a resonator is provided. The resonator includes a piezoelectric resonance part, a single crystal resonance part, and a coupling part. The piezoelectric resonance part includes a first electrode, a piezoelectric layer, and a second electrode that are sequentially stacked. When a drive signal is loaded between the first electrode and the second electrode, the piezoelectric resonance part can resonate under an action of the drive signal. A material of the single crystal resonance part is a single crystal material or a doped single crystal material. For example, the single crystal material may be single crystal silicon, and the doped single crystal material may be single crystal silicon whose doping concentration is greater than or equal to the 19th power of 10. The piezoelectric resonance part and the single crystal resonance part can resonate, and the piezoelectric resonance part and the single crystal resonance part are connected and coupled through the coupling part. Because the piezoelectric resonance part and the single crystal resonance part can be coupled through the coupling part, the single crystal resonance part is in a vibration direction of the piezoelectric resonance part.

In the resonator provided in this application, the material of the single crystal resonance part is the single crystal material or the doped single crystal material, and does not include another material. It may be learned that the single crystal resonance part is a component made of the single crystal material or the doped single crystal material. Generally, a resonance part that includes only a single crystal material or a doped single crystal material does not have problems such as a thermoelastic loss caused by material coefficient mismatch between a plurality of layers of materials. Therefore, an energy loss of the single crystal resonance part is low, and Q of the single crystal resonance part is high. The piezoelectric resonance part is coupled to the single crystal resonance part, so that Q of the resonator including the piezoelectric resonance part and the single crystal resonance part is higher than Q of the piezoelectric resonance part. Therefore, Q of the resonator can be increased, an energy loss of the resonator can be reduced, and performance of the resonator can be improved.

The piezoelectric resonance part includes an electrode. The single crystal resonance part does not include an electrode. The piezoelectric resonance part and the single crystal resonance part are coupled through the coupling part. In this way, the electrode of the piezoelectric resonance part may be connected to a control circuit, and the control circuit inputs the drive signal to the electrodes of the piezoelectric resonance part, to drive the resonator to resonate. In addition, because electromechanical conversion efficiency of the piezoelectric resonance part is high, loading a drive signal on the piezoelectric resonance part can reduce dynamic impedance of the resonator compared with loading a drive signal on the single crystal resonance part.

For example, the resonator may include two single crystal resonance parts and two coupling parts that are in one-to-one correspondence with the two single crystal resonance parts. The two single crystal resonance parts are located on two opposite sides of the piezoelectric resonance part. The piezoelectric resonance part and the single crystal resonance parts are connected and coupled through the coupling parts corresponding to the single crystal resonance parts. In this case, the two single crystal resonance parts and the two coupling parts are both oppositely distributed on two sides of the piezoelectric resonance part, so that the entire resonator has a symmetrical structure. This facilitates resonance of the resonator.

It should be noted that, in this application, an example in which the resonator includes the two single crystal resonance parts and the two coupling parts is used. Certainly, the resonator may include only one single crystal resonance part and one coupling part, or the resonator may include more than two single crystal resonance parts and more than two coupling parts. This is not limited in this application.

The following separately describes the parts of the resonator.

(1) Single crystal resonance part

For the single crystal resonance part, a vibration mode of the single crystal resonance part is not limited in this application. For example, there are various vibration modes of the single crystal resonance part. For example, the vibration mode of the single crystal resonance part is a breathing mode, a lame (lamé or lame) mode, a square extensional (square extensional, SE) mode, a length extensional (length extensional, LE) mode, a width extensional (width extensional, WE) mode, or the like.

There may be various shapes of the single crystal resonance part. For example, an orthographic projection of the single crystal resonance part on a reference plane parallel to the piezoelectric layer of the piezoelectric resonance part may be a ring having a curvature radius in an outer ring and having a curvature radius in an inner ring, a circle, an ellipse, a ring having a plurality of curvature radiuses in an outer ring, or a rectangle (for example, a square). An orthographic projection of an object on a reference plane indicates a projection formed on the reference plane when light perpendicular to the reference plane is irradiated to the reference plane from a side that is of the object and that is away from the reference plane.

Optionally, when the orthographic projection is a ring having a plurality of curvature radiuses in an outer ring, a curvature radius of each position in the outer ring may be negatively correlated with a ring width of the position. In this case, a curvature radius of a position with a large ring width in the outer ring is small, and a curvature radius of a position with a small ring width in the outer ring is large. When the orthographic projection is a ring having a plurality of curvature radiuses in an outer ring, an inner ring of the ring may have one curvature radius. Certainly, the inner ring of the ring may alternatively have a plurality of curvature radiuses. This is not limited in this application.

When the vibration mode, shape, and/or quantity of the single crystal resonance part change, a temperature coefficient of frequency (temperature coefficient of frequency, TCF) turnover point of the resonator changes, so that the resonator can support different TCF turnover points.

(2) Piezoelectric resonance part

For the piezoelectric resonance part, a vibration mode of the piezoelectric resonance part is an LE mode or a WE mode. Alternatively, a vibration mode of the piezoelectric resonance part may not be an LE mode or a WE mode. For example, the vibration mode of the piezoelectric resonance part is a breathing mode, a lame mode, an SE mode, or the like.

A material of the piezoelectric resonance part may include a single crystal material or a doped single crystal material. The piezoelectric resonance part includes a first electrode, a piezoelectric layer, and a second electrode. A material of at least one of the three layers may include a single crystal material or a doped single crystal material. For example, a material of the first electrode includes a single crystal material or a doped single crystal material. When a portion of the resonator includes a single crystal material or a doped single crystal material, Q of the entire resonator is high. Therefore, when the material of the piezoelectric resonance part includes a single crystal material or a doped single crystal material, Q of the piezoelectric resonance part is high. In this way, Q of the entire resonator can be further increased.

A thickness of each film layer in the piezoelectric resonance part is not limited in this application. Optionally, a thickness of the first electrode, a thickness of the piezoelectric layer, and a thickness of the second electrode in the piezoelectric resonance part are in a descending order. It may be learned through simulation calculation that, when the thickness of the first electrode, the thickness of the piezoelectric layer, and the thickness of the second electrode are in the descending order, performance of the piezoelectric resonance part is high, and performance of the entire resonance part is high. For example, the thickness of the first electrode is greater than or equal to ten times the thickness of the piezoelectric layer, and a range of the thickness of the first electrode may be [10 micrometers, 100 micrometers].

It should be noted that, in this application, an example in which the piezoelectric resonance part includes the first electrode, the piezoelectric layer, and the second electrode is used. Optionally, the piezoelectric resonance part may further include another film layer. For example, the piezoelectric resonance part further includes a substrate layer located on a side that is of the first electrode and that is away from the piezoelectric layer. In this case, the coupling part may be connected to the substrate layer, the first electrode, or the like.

(3) Coupling part

The coupling part needs to connect and couple the piezoelectric resonance part and the single crystal resonance part. To improve a coupling effect, the coupling part may connect a point with strongest vibration of the piezoelectric resonance part and a point with strongest vibration of the single crystal resonance part.

It may be learned from the foregoing content that, when a portion of the resonator includes a single crystal material or a doped single crystal material, Q of the entire resonator is high. Therefore, a material of the coupling part in this application may also include a single crystal material or a doped single crystal material. In this way, Q of the resonator is further increased. In this application, an example in which the coupling part includes only a single crystal material or a doped single crystal material is used. Optionally, the material of the coupling part may also include a material in addition to the single crystal material or the doped single crystal material, or the material of the coupling part may not include the single crystal material or the doped single crystal material.

For the piezoelectric resonance part, the single crystal resonance part, and the coupling part of the resonator, the first electrode, the coupling part, and the single crystal resonance part may be made of a same material and may have a same thickness. In this case, the first electrode, the coupling part, and the single crystal resonance part may be simultaneously prepared on a same material layer. Certainly, the first electrode, the coupling part, and the single crystal resonance part may alternatively be made of different materials and have different thicknesses. This is not limited in this application.

Shapes of the piezoelectric resonance part, the single crystal resonance part, and the coupling part are not limited in this application. For example, both a first orthographic projection of the piezoelectric resonance part on the reference plane parallel to the piezoelectric layer and a second orthographic projection of the coupling part on the reference plane are strips, and a third orthographic projection of the single crystal resonance part on the reference plane is a ring. In addition, a width of the first orthographic projection, a maximum ring width of the third orthographic projection, and a width of the second orthographic projection are in a descending order. It may be learned through simulation calculation that, when the width of the first orthographic projection, the ring width of the third orthographic projection, and the width of the second orthographic projection are in the descending order, performance of the resonator is high. For example, the width of the first orthographic projection is greater than or equal to twice the ring width of the third orthographic projection. A range of the width of the first orthographic projection may be [10 micrometers, 300 micrometers].

An orthographic projection of the piezoelectric resonance part on the reference plane is located outside an orthographic projection of the single crystal resonance part on the reference plane. Certainly, the orthographic projection of the piezoelectric resonance part on the reference plane and the orthographic projection of the single crystal resonance part on the reference plane may alternatively overlap.

Further, the resonator provided in this application further includes an anchoring part (also referred to as an anchor). The anchoring part is connected to a vibration node (a position with a smallest amplitude of the piezoelectric resonance part) of the piezoelectric resonance part, and is spaced from the single crystal resonance part. The anchoring part is configured to anchor a portion of the resonator other than the anchoring part. It may be learned that, in this application, the portion of the resonator other than the anchoring part is anchored on the piezoelectric resonance part. Certainly, the anchoring part may alternatively be connected to a vibration node (a position with a smallest amplitude of the single crystal resonance part) of the single crystal resonance part. Compared with the connection between the anchoring part and the single crystal resonance part, the connection between the anchoring part and the piezoelectric resonance part brings a smaller decrement of Q of the resonator, thereby ensuring that Q of the resonator is higher. In addition, when the anchoring part is connected to the vibration node of the piezoelectric resonance part, or when the anchoring part is connected to the vibration node of the single crystal resonance part, an energy loss on the anchoring part is low, and an energy loss caused by the anchoring part to the resonator is low.

It may be learned from the foregoing content that the piezoelectric resonance part includes a plurality of layers of structures, and the anchoring part needs to be connected to the piezoelectric resonance part. In this case, the anchoring part may be connected to one layer of structure (for example, the first electrode) or at least two layers of structures (for example, each layer of structure) in the piezoelectric resonance part. Optionally, the anchoring part may be a strip, and one end of the anchoring part in a length direction is connected to the piezoelectric resonance part.

The resonator may include two groups of anchoring parts located on two opposite sides of the piezoelectric resonance part. Each group of anchoring parts includes one anchoring part. Optionally, each group of anchoring parts may alternatively include a plurality of anchoring parts. Alternatively, the resonator may include one group of anchoring parts located on a side of the piezoelectric resonance part. This is not limited in this application.

Optionally, a first arrangement direction of the piezoelectric resonance part and the single crystal resonance part is different from a second arrangement direction of the piezoelectric resonance part and the anchoring part, and both the first arrangement direction and the second arrangement direction are parallel to the piezoelectric layer. Optionally, the first arrangement direction may alternatively not be perpendicular to the second arrangement direction. This is not limited in this application.

Further, when the material of the single crystal resonance part is a doped single crystal material, the resonator may further include an auxiliary electrode corresponding to the single crystal resonance part, and a gap exists between the auxiliary electrode and the single crystal resonance part.

It should be noted that, if the resonator includes a plurality of single crystal resonance parts, the resonator may include a plurality of auxiliary electrodes that are in one-to-one correspondence with the plurality of single crystal resonance parts, a gap exists between each auxiliary electrode and a corresponding single crystal resonance part, the gap between the auxiliary electrode and the corresponding single crystal resonance part is less than a gap between the auxiliary electrode and another single crystal resonance part, and the another single crystal resonance part is any single crystal resonance part of the plurality of single crystal resonance parts other than the single crystal resonance part corresponding to the auxiliary electrode.

Optionally, a maximum gap between the auxiliary electrode and the corresponding single crystal resonance part is less than 2 micrometers. A position relationship between the single crystal resonance part and the corresponding auxiliary electrode may be any position relationship. For example, in this application, an example in which the single crystal resonance part is a ring surrounding the corresponding auxiliary electrode is used.

A material of the auxiliary electrode is a conductive material. Optionally, the material of the auxiliary electrode may be the same as the material of the single crystal resonance part, and the auxiliary electrode and the single crystal resonance part are located at a same layer. In this way, a same material layer may be processed, to simultaneously prepare the auxiliary electrode and the single crystal resonance part. In this application, the first electrode of the piezoelectric resonance part, the single crystal resonance part, the coupling part, and the auxiliary electrode are all made of a same material. Therefore, a same material layer may be processed, to simultaneously prepare the first electrode, the single crystal resonance part, the coupling part, and the auxiliary electrode.

Because the resonator includes the auxiliary electrode, the auxiliary electrode may be connected to the control circuit, so that the control circuit may provide a drive signal for the resonator through a first electrode group including the auxiliary electrode, to drive the resonator to resonate and generate a vibration signal. For example, the first electrode group includes the first electrode, the second electrode, and the auxiliary electrode; or the first electrode group includes the first electrode and the auxiliary electrode. Optionally, the first electrode group may not include the auxiliary electrode. For example, the first electrode group includes the first electrode and the second electrode.

When the resonator includes the auxiliary electrode, the control circuit may further receive, through a second electrode group including the auxiliary electrode, a vibration signal generated by resonance of the resonator. For example, the second electrode group includes the first electrode, the second electrode, and the auxiliary electrode; or the second electrode group includes the first electrode and the auxiliary electrode. Optionally, the second electrode group may not include the auxiliary electrode. For example, the second electrode group includes the first electrode and the second electrode.

The first electrode group and the second electrode group may be the same or may be different. This is not limited in this application. When the second electrode group includes the first electrode, the second electrode, and the auxiliary electrode, the control circuit is configured to receive, through the auxiliary electrode, the first electrode, and the second electrode, a vibration signal generated by resonance of the resonator. Because a large quantity of electrodes are used by the control circuit to receive the vibration signal, an area of the electrodes for receiving the vibration signal can be increased, a current of the vibration signal received by the control circuit can be increased, and dynamic impedance of the resonator can be reduced.

Further, various resonators provided in this application may have a symmetrical structure. For example, an orthographic projection of the resonator on the reference plane parallel to the piezoelectric layer may be an axial symmetric figure. The axial symmetric figure has a first symmetry axis that passes through an orthographic projection of the anchoring part on the reference plane, and/or the axial symmetric figure has a second symmetry axis that passes through the orthographic projection of the single crystal resonance part on the reference plane. In this application, an example in which the axial symmetric figure has both the first symmetry axis and the second symmetry axis is used.

For example, the resonator includes two anchoring parts distributed on two opposite sides of the piezoelectric resonance part, orthographic projections of the anchoring part on the reference plane are rectangles, and the first symmetry axis may pass through a central axis of the orthographic projections of the two anchoring parts on the reference plane. The resonator includes two single crystal resonance parts located on two opposite sides of the piezoelectric resonance part, orthographic projections of the single crystal resonance part on the reference plane are rings, and the second symmetry axis may pass through centers of the orthographic projections of the two single crystal resonance parts on the reference plane.

Optionally, an extension direction of the second symmetry axis may have a specific relationship with a crystal direction of the single crystal resonance part. For example, the extension direction of the second symmetry axis is a crystal direction [100] of the single crystal resonance part; the extension direction of the second symmetry axis is a crystal direction [110] of the single crystal resonance part; or the extension direction of the second symmetry axis is between a crystal direction [100] and a crystal direction [110] of the single crystal resonance part. In this case, an included angle between the extension direction of the second symmetry axis and the crystal direction [110] of the single crystal resonance part is greater than 0 degrees and less than 45 degrees.

It may be learned that, in this application, there may be a plurality of extension directions of the second symmetry axis. In addition, when the second symmetry axis extends in different extension directions, the resonator has different TCF turnover points, so that the resonator can support different TCF turnover points.

According to a second aspect, a resonant system is provided. The resonant system includes any resonator provided in this application and a control circuit. The control circuit is configured to provide a drive signal for the resonator, and receive a vibration signal generated by resonance of the resonator.

For example, the control circuit may provide a drive signal for the resonator through a connected first electrode group, to drive the resonator to resonate and generate a vibration signal. The control circuit may further receive the vibration signal through a connected second electrode group. For one electrode group of the first electrode group and the second electrode group, the electrode group includes a first electrode and a second electrode. Alternatively, a material of a single crystal resonance part is a doped single crystal material, the resonator includes an auxiliary electrode corresponding to the single crystal resonance part, and the electrode group includes a first electrode, a second electrode, and the auxiliary electrode. Alternatively, a material of a single crystal resonance part is a doped single crystal material, the resonator includes an auxiliary electrode, and the electrode group includes a first electrode and the auxiliary electrode. The first electrode group and the second electrode group may be the same or may be different. This is not limited in this application.

The resonant system provided in this application may be any system including a resonator and a control circuit, for example, an oscillator (also referred to as a clock generator), a sensor, a communication device (for example, a wireless communication device), or a wearable device.

According to a third aspect, a signal obtaining method for the control circuit in the resonant system is provided. The method includes: The control circuit provides a drive signal for the resonator through a connected first electrode group in the resonator, to drive the resonator to resonate and generate a vibration signal. In addition, the control circuit receives the vibration signal through a connected second electrode group in the resonator.

For one electrode group of the first electrode group and the second electrode group, the electrode group includes a first electrode and a second electrode. Alternatively, a material of a single crystal resonance part is a doped single crystal material, the resonator includes an auxiliary electrode corresponding to the single crystal resonance part, and the electrode group includes a first electrode, a second electrode, and the auxiliary electrode. Alternatively, a material of a single crystal resonance part is a doped single crystal material, the resonator includes an auxiliary electrode, and the electrode group includes a first electrode and the auxiliary electrode. The first electrode group and the second electrode group may be the same or may be different. This is not limited in this application.

When the second electrode group includes the first electrode, the second electrode, and the auxiliary electrode, the control circuit receives, through the three types of electrodes, a vibration signal generated by resonance of the resonator. In this case, because a large quantity of electrodes are used by the control circuit to receive the vibration signal, an area of the electrodes for receiving the vibration signal can be increased, a current of the vibration signal received by the control circuit can be increased, and dynamic impedance of the resonator can be reduced.

According to a fourth aspect, this application provides a resonator. The resonator includes an electrostatic resonance layer. A material of the electrostatic resonance layer may be a single crystal material, a polycrystalline material, a doped single crystal material, a doped polycrystalline material, or the like. The electrostatic resonance layer has a plurality of target crystal directions parallel to the electrostatic resonance layer, Young's moduli of the electrostatic resonance layer in different target crystal directions are different. The electrostatic resonance layer has anisotropy. In addition, a length of the electrostatic resonance layer on a straight line parallel to any target crystal direction is negatively correlated with a Young's modulus of the electrostatic resonance layer in the any target crystal direction. The straight line passes through a center of the electrostatic resonance layer, and is parallel to the electrostatic resonance layer. A length of the electrostatic resonance layer on a straight line is a length of a portion that intersects the electrostatic resonance layer and that is of the straight line.

The electrostatic resonance layer may be a ring, and curvature of each position in an inner ring and an outer ring of the ring is greater than zero; or the electrostatic resonance layer may be a convex shape, and curvature of each edge position of the convex shape is greater than zero.

In the resonator provided in this application, a length of the electrostatic resonance layer on a straight line that is parallel to any target crystal direction and that passes through a center of the electrostatic resonance layer is negatively correlated with a Young's modulus of the electrostatic resonance layer in the any target crystal direction. It may be learned that, when a Young's modulus of the electrostatic resonance layer in a target crystal direction is large, in this application, a small length of the electrostatic resonance layer on a straight line that is parallel to the target crystal direction and that passes through the center of the electrostatic resonance layer is set. When a Young's modulus of the electrostatic resonance layer in a target crystal direction is small, in this application, a large length of the electrostatic resonance layer on a straight line that is parallel to the target crystal direction and that passes through the center of the electrostatic resonance layer is set. A stiffness of a portion of the electrostatic resonance layer in any target crystal direction at the center is positively correlated with a Young's modulus in the target crystal direction and a length of the electrostatic resonance layer on a straight line that is parallel to the target crystal direction and that passes through the center of the electrostatic resonance layer. Therefore, according to the "negative correlation" in this application, stiffnesses of portions of the electrostatic resonance layer in all the target crystal directions at the center can be uniform. When the electrostatic resonance layer vibrates, vibration amplitudes of the portions of the electrostatic resonance layer in all the target crystal directions at the center are uniform, and heat generated by these portions is uniform. This reduces a heat gradient and reduces a thermoelastic loss.

Optionally, the length $C_\theta'$ of the electrostatic resonance layer on the straight line parallel to the any target crystal direction is correlated with $C_\theta$. For example, an absolute value of a difference between $C_\theta'$ and $C_\theta$ is less than or equal to $0.05 \times k \times C_0$ (for example, the difference between $C_\theta'$ and $C_\theta$ is zero). $\theta$ represents an included angle between the any target crystal direction

$$C_\theta = \left(\frac{E_0}{E_\theta}\right)^k \times C_0$$

and a reference direction; ; $E_0$ represents a Young's modulus of the electrostatic resonance layer in a target crystal direction parallel to the reference direction; $E_\theta$ represents a Young's modulus of the electrostatic resonance layer in the any target crystal direction; $C_0$ represents a length of the electrostatic resonance layer on a straight line parallel to the reference direction; and k is a constant greater than zero. It may be

$$C_\theta = \left(\frac{E_0}{E_\theta}\right)^k \times C_0$$

learned from the equation that $C_\theta$ is negatively correlated with $E_\theta$, and $C_\theta'$ is close to $C_\theta$. Therefore, $C_\theta'$ is also negatively correlated with $E_\theta$. It may be understood that $C_\theta$ may alternatively be calculated according to an equation different from the equation

$$C_\theta = \left(\frac{E_0}{E_\theta}\right)^k \times C_0$$

. For example,

$$C_\theta = \left(\frac{E_0}{E_\theta}\right)^k \times C_0 \times A$$

, where A is a coefficient.

In the foregoing embodiment, $E_0$ may be less than $E_\theta$. In other words, $E_0$ is a minimum value of the Young's moduli of the electrostatic resonance layer in all the target crystal directions. The target crystal direction parallel to the reference direction may be a crystal direction [100] or another target crystal direction. It may be understood that $E_0$ may alternatively not be a minimum value of the Young's moduli of the electrostatic resonance layer in all the target crystal directions. This is not limited in embodiments of this application.

Further, k in the foregoing equation is a constant greater than zero. A value of k is closely related to a thermoelastic loss of the electrostatic resonance layer. A proper value of k can further reduce the thermoelastic loss.

For example, when the electrostatic resonance layer is a ring, and curvature of each position in an inner ring and an outer ring of the ring is greater than zero, $0.3 \leq k \leq 0.8$. For example, k = 0.55. When the electrostatic resonance layer is a ring, and the curvature of each position in the inner ring and the outer ring of the ring is greater than zero, if k = 0.55, displacements of all positions in the electrostatic resonance layer are uniform, and the thermoelastic loss is the lowest.

For another example, when the electrostatic resonance layer is a convex shape, and curvature of each position at an outer edge of the convex shape is greater than zero, $3 \leq k \leq 5$. For example, k = 4. When k = 4, the thermoelastic loss of the electrostatic resonance layer is the lowest.

Further, the resonator includes an auxiliary electrode located at a same layer as the electrostatic resonance layer. Vibration of the electrostatic resonance layer may be driven by the auxiliary electrode, and the auxiliary electrode may also detect a vibration signal generated by vibration of the electrostatic resonance layer. The auxiliary electrode is spaced from the electrostatic resonance layer, and the auxiliary electrode and the electrostatic resonance layer have a same spacing in different target crystal directions of the electrostatic resonance layer. A spacing between the auxiliary electrode and the electrostatic resonance layer in a target crystal direction of the electrostatic resonance layer is a length of a portion that is located between the auxiliary electrode and the electrostatic resonance layer and that is of a straight line passing through the center of the electrostatic resonance layer and parallel to the target crystal direction.

It may be learned that, in this application, the auxiliary electrode and the electrostatic resonance layer are matched in shape, so that a spacing between the auxiliary electrode and the electrostatic resonance layer at each position remains at a specific value. In this way, when the electrostatic resonance layer is driven by the auxiliary electrode, strength of electric fields applied by the auxiliary electrode to all positions in the electrostatic resonance layer is consistent, so that vibration statuses at all the positions in the electrostatic resonance layer can be further consistent, and the thermoelastic loss is further reduced.

Further, regardless of whether the resonator includes the auxiliary electrode, the resonator may further include a piezoelectric resonance portion.

For example, the resonator further includes a third electrode, a piezoelectric oscillator, and a fourth electrode, and the third electrode, the piezoelectric oscillator, the fourth electrode, and the electrostatic resonance layer are sequentially stacked. In this case, the third electrode and the fourth electrode may be configured to drive the piezoelectric oscillator to vibrate, and when the piezoelectric oscillator vibrates, can drive the electrostatic resonance layer to vibrate. For another example, the electrostatic resonance layer is conductive, and the electrostatic resonance layer may be reused as a fourth electrode. The resonator further includes a third electrode and a piezoelectric oscillator. The third electrode, the piezoelectric oscillator, and the electrostatic resonance layer are sequentially stacked. In this case, the third electrode and the electrostatic resonance layer may be configured to drive the piezoelectric oscillator to vibrate, and when the piezoelectric oscillator vibrates, can drive the electrostatic resonance layer to vibrate.

The first aspect provides the resonator that includes "the coupling part, the piezoelectric resonance part, and the single crystal resonance part", and the fourth aspect provides the resonator that has the "negative correlation" characteristic. The characteristic of the resonator that has the "negative correlation" characteristic may also be applied to the resonator that includes "the coupling part, the piezoelectric resonance part, and the single crystal resonance part".

For example, in the resonator that includes "the coupling part, the piezoelectric resonance part, and the single crystal resonance part", Young's moduli of the single crystal resonance part in different target crystal directions are different. The single crystal resonance part is layered. The target crystal direction is parallel to the single crystal resonance part. A length of the single crystal resonance part on a straight line parallel to any target crystal direction is negatively correlated with a Young's modulus of the single crystal resonance part in the any target crystal direction. The straight line passes through a center of the single crystal resonance part.

Optionally, an absolute value of a difference between $c_\theta{}'$ and $C_\theta$ is less than or equal to $0.05 \times k \times C_0$, where $C_\theta{}'$ represents the length of the single crystal resonance part on the straight line parallel to the any target crystal direction; $\theta$ represents an included angle between the any target crystal direction and a reference direction;

$$C_\theta = \left(\frac{E_0}{E_\theta}\right)^k \times C_0$$

; $E_0$ represents a Young's modulus of the single crystal resonance part in a target crystal direction parallel to the reference direction; $E_\theta$ represents the Young's modulus of the single crystal resonance part in the any target crystal direction; $C_0$ represents a length of the single crystal resonance part on a straight line parallel to the reference direction; and k is a constant greater than zero.

Optionally, $E_0$ is less than $E_\theta$.

Optionally, the single crystal resonance part is a ring, and curvature of each position in an inner ring and an outer ring of the ring is greater than zero; and $0.3 \leq k \leq 0.8$.

For example, k = 0.55.

Optionally, the single crystal resonance part is a convex shape, and curvature of each position at an outer edge of the convex shape is greater than zero; and $3 \leq k \leq 5$. For example, k = 4.

Optionally, the resonator further includes an auxiliary electrode corresponding to the single crystal resonance part. The auxiliary electrode and the single crystal resonance part are located at a same layer, and a gap exists between the auxiliary electrode and the single crystal resonance part. When the resonator includes the auxiliary electrode, the auxiliary electrode and the electrostatic resonance layer have a same spacing in different target crystal directions of the electrostatic resonance layer.

Optionally, the resonator may also include a piezoelectric resonance portion other than the piezoelectric resonance part. For example, the piezoelectric resonance portion may include a third electrode, a piezoelectric oscillator, and a fourth electrode, and the third electrode, the piezoelectric oscillator, the fourth electrode, and the single crystal resonance part are sequentially stacked. In this case, the third electrode and the fourth electrode may be configured to drive the piezoelectric oscillator to vibrate, and when the piezoelectric oscillator vibrates, can drive the single crystal resonance part to vibrate. For another example, the single crystal resonance part is conductive, and the single crystal resonance part can be reused as the foregoing fourth electrode. In this case, the resonator further includes a third electrode and a piezoelectric oscillator, and the third electrode, the piezoelectric oscillator, and the single crystal resonance part are sequentially stacked. In this case, the third electrode and the single crystal resonance part may be configured to drive the piezoelectric oscillator to vibrate, and when the piezoelectric oscillator vibrates, can drive the single crystal resonance part to vibrate.

The resonator provided in the first aspect may also have at least some characteristics of the resonator provided in the fourth aspect. The resonator in the resonant system provided in the second aspect may be the resonator that includes "the coupling part, the piezoelectric resonance part, and the single crystal resonance part" and that is provided in the first aspect, or may be the resonator that has the "negative correlation" characteristic and that is provided in the fourth aspect. The control circuit in the resonant system is configured to: provide a drive signal for the resonator through an electrode in the resonator, to drive the resonator to resonate and generate a vibration signal; and receive the vibration signal through an electrode in the resonator. The resonant system may be an oscillator, a sensor, or the like.

Both the first electrode group and the second electrode group in the signal obtaining method that is used for the control circuit in the resonant system and that is provided in the third aspect may select proper electrodes according to corresponding resonators.

For effects of the second aspect and the third aspect, refer to effects of corresponding features in the first aspect. Details are not described herein again in this application.

**BRIEF DESCRIPTION OF DRAWINGS**

FIG. 1 is a phase noise spectrum of an oscillator according to an embodiment of this application;
FIG. 2 is a diagram of a TCF curve of a resonator in an oscillator according to an embodiment of this application;
FIG. 3 is a diagram of a structure of a piezoelectric resonator according to an embodiment of this application;
FIG. 4 is a top view of a resonator according to an embodiment of this application;
FIG. 5 is a diagram of a cross section AA in FIG. 4;
FIG. 6 is a top view of another resonator according to an embodiment of this application;
FIG. 7 is a top view of another resonator according to an embodiment of this application;
FIG. 8 is a top view of another resonator according to an embodiment of this application;
FIG. 9 is a top view of another resonator according to an embodiment of this application;
FIG. 10 is a top view of another resonator according to an embodiment of this application;
FIG. 11 is a top view of another resonator according to an embodiment of this application;
FIG. 12 is a diagram of a cross section BB in FIG. 11;
FIG. 13 is a diagram of an orthographic projection of the resonator shown in FIG. 4 according to an embodiment of this application;
FIG. 14 is a diagram of a relationship between a second symmetry axis and crystal directions of a single crystal resonance part according to an embodiment of this application;
FIG. 15 is a diagram of another relationship between a second symmetry axis and crystal directions of a single crystal resonance part according to an embodiment of this application.
FIG. 16 is a diagram of another relationship between a second symmetry axis and crystal directions of a single crystal resonance part according to an embodiment of this application.
FIG. 17 is a diagram of a TCF curve of a resonator according to an embodiment of this application;
FIG. 18 is a diagram of a TCF curve of another resonator according to an embodiment of this application;
FIG. 19 is a diagram of a TCF curve of another resonator according to an embodiment of this application;
FIG. 20 is a diagram of a dynamic impedance curve and a phase curve of a resonator according to an embodiment of this application;
FIG. 21 is a diagram of a cross section of a resonator according to an embodiment of this application;
FIG. 22 is a diagram of a manufacturing process of a resonator according to an embodiment of this application;
FIG. 23 is a diagram of a cross section of another resonator according to an embodiment of this application;
FIG. 24 is a diagram of a manufacturing process of another resonator according to an embodiment of this application;
FIG. 25 is a diagram of a resonant system according to an embodiment of this application;
FIG. 26 is a diagram of another resonant system according to an embodiment of this application;
FIG. 27 is a diagram of an oscillator according to an embodiment of this application;
FIG. 28 is a flowchart of a signal obtaining method according to an embodiment of this application;
FIG. 29 is a diagram of Young's moduli of an electrostatic resonance layer in some target crystal directions according to an embodiment of this application;
FIG. 30 is a diagram of a structure of an electrostatic resonance layer according to an embodiment of this application;
FIG. 31 is a diagram of another structure of an electrostatic resonance layer according to an embodiment of this application;
FIG. 32 is a diagram of a curve of a relationship between k and QTED according to an embodiment of this application;
FIG. 33 is a diagram of a first-order breathing mode of an electrostatic resonance layer according to an embodiment of this application;
FIG. 34 is a diagram of a second-order breathing mode of an electrostatic resonance layer according to an embodiment of this application;
FIG. 35 is a diagram of a position relationship between an electrostatic resonance layer and an auxiliary electrode according to an embodiment of this application;
FIG. 36 is a diagram of another position relationship between an electrostatic resonance layer and an auxiliary electrode according to an embodiment of this application;
FIG. 37 is a diagram of a cross section of another resonator according to an embodiment of this application;
FIG. 38 is a diagram of a cross section of another resonator according to an embodiment of this application; and
FIG. 39 is a diagram of a structure of a resonator that includes a coupling part, a piezoelectric resonance part, and a single crystal resonance part according to an embodiment of this application.

## DESCRIPTION OF EMBODIMENTS

To make principles and technical solutions of this application clearer, the following further describes implementations of this application in detail with reference to the accompanying drawings.

An embodiment of this application further provides a resonator. The resonator may be used in a resonant system, for example, an oscillator (also referred to as a clock generator), a sensor, a communication device (for example, a wireless communication device), or a wearable device.

The resonator is a component based on a mechanical resonance effect. The resonator can resonate under an action of a drive signal, to generate a vibration signal (also referred to as a frequency signal). Main performance parameters of the resonator include a resonance frequency, Q, dynamic impedance, a TCF, and the like.

Q is a most important performance parameter of the resonator, and a Q value has a great impact on performance of the resonator.

For example, when the resonator is used in the sensor, a high Q value can improve resolution and sensitivity of the sensor.

For another example, when the resonator is used in the oscillator, a vibration signal generated by the resonator is used as a frequency reference of the oscillator. In this case, a high Q value can reduce dynamic impedance of the resonator, reduce phase noise of the oscillator (increase a signal-to-noise ratio), and improve frequency stability of the oscillator.

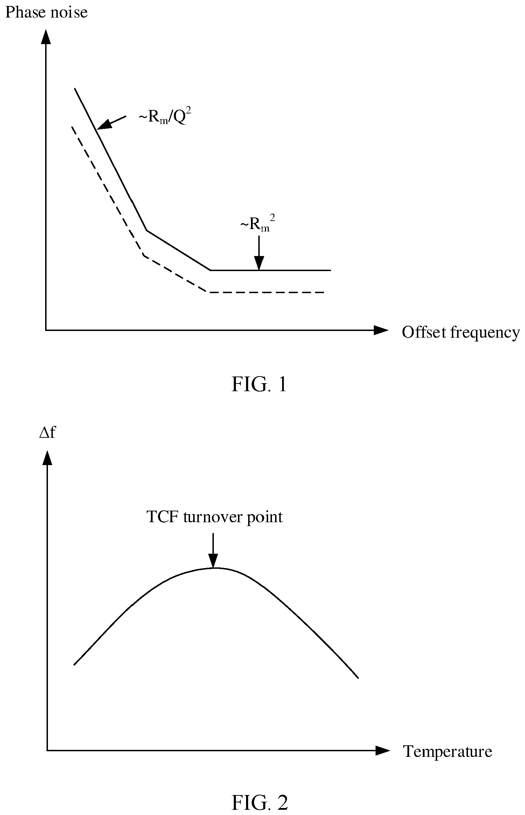

For example, FIG. 1 is a phase noise spectrum of an oscillator according to an embodiment of this application. In FIG. 1, a horizontal axis represents an offset frequency (offset frequency) that is also referred to as a frequency offset, and indicates an offset from a center frequency, and a vertical axis represents phase noise of the oscillator. As shown in FIG. 1, when the Q value of the resonator increases and/or the dynamic impedance Rm decreases, the phase noise spectrum changes from a solid line in FIG. 1 to a dashed line. It may be learned that a high Q value and/or low dynamic impedance Rm of the resonator can reduce near-carrier phase noise of the oscillator, and low dynamic impedance Rm can reduce far-carrier phase noise of the oscillator. Therefore, resonators with high Q values and low dynamic impedance are the basis for implementing high performance oscillators.

FIG. 2 is a diagram of a TCF curve of a resonator in an oscillator according to an embodiment of this application. In FIG. 2, a horizontal axis represents a temperature of an environment in which the resonator is located, and a vertical axis represents a frequency drift $\triangle f$ (indicating an offset of a frequency of a signal output by the resonator relative to a reference frequency) of the resonator. In addition, FIG. 2 further shows a TCF turnover point of the oscillator. When the resonator in the oscillator operates near a temperature of the TCF turnover point, a frequency drift of the resonator is stable, and a frequency drift of the oscillator is also stable. Therefore, the TCF turnover point determines a temperature range in which the resonator can stably operate. When the resonator is used in the oscillator, to easily enable the resonator to operate near the temperature of the TCF turnover point, the TCF turnover point of the resonator may be designed to have a high temperature, and the temperature of the environment in which the resonator is located is stabilized near the temperature of the TCF turnover point by using a heater, thereby implementing an oscillator with high stability.

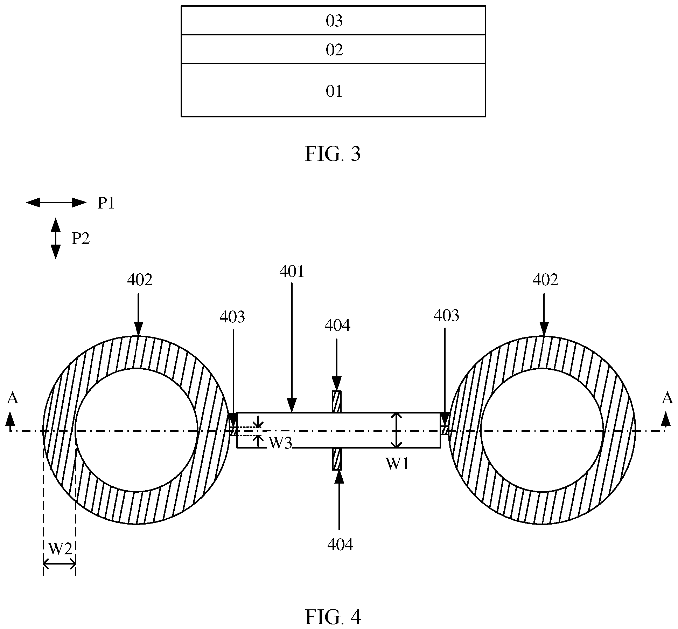

Further, there are various types of resonators. A piezoelectric resonator is a common resonator. As shown in FIG. 3, the piezoelectric resonator includes a first electrode 01, a piezoelectric layer 02, and a second electrode 03 that are sequentially stacked. When a drive signal is loaded on the first electrode 01 and the second electrode 03, the piezoelectric resonator can resonate under an action of the drive signal, so as to generate a vibration signal. However, Q of the piezoelectric resonator (for example, a micro-electro-mechanical system (micro-electro-mechanical system, MEMS) piezoelectric resonator) is low. In addition, during application of a resonator with a high Q value, performance of the piezoelectric resonator is positively correlated with Q of the piezoelectric resonator. As a result, performance of the piezoelectric resonator is poor.

Generally, Q of the resonator satisfies the following equation:

$$\frac{1}{Q} = \frac{1}{Q_{air}} + \frac{1}{Q_{TED}} + \frac{1}{Q_{material}} + \frac{1}{Q_{anchor}} + \frac{1}{Q_{load}}$$

It may be learned that Q of the resonator is related to Q corresponding to five types of energy losses of the resonator. Q corresponding to the five types of energy losses is Q ($Q_{air}$) corresponding to an air damping loss, Q ($Q_{TED}$) corresponding to a thermoelastic loss, Q ($Q_{material}$) corresponding to a material loss, Q ($Q_{anchor}$) corresponding to an anchor loss, and Q ($Q_{load}$) corresponding to an electrical load loss. Q corresponding to the thermoelastic loss is a main factor restricting the Q value of the piezoelectric resonator.

The thermoelastic loss is caused by a thermal gradient generated during vibration of the resonator. During vibration of the resonator, a strain field is inevitably generated inside the resonator. Generally, stress applied to each portion of the resonator is uneven, and such stress unevenness forms a strain gradient, thereby generating a thermal gradient. The thermal gradient causes the resonator to generate irreversible heat flow during vibration, causing a mechanical energy loss.

Currently, heat transfer between a hot end and a cold end that is caused by uneven stress may be isolated by etching holes and grooves in an electrostatic resonator. This reduces heat flow and reduces the thermoelastic loss of the resonator. However, because the piezoelectric resonator is of a stacked structure, and a thermal gradient generated by a stress gradient of the piezoelectric resonator is vertically distributed (for example, a direction of the thermal gradient is a stacking direction of the film layers in FIG. 3), it is quite difficult to process holes and grooves in a direction (a left-right direction in FIG. 3) perpendicular to the thermal gradient. In addition, even if the holes and the grooves can be processed in the piezoelectric resonator, because air or vacuum exists in the holes and the grooves, vibration generated by the piezoelectric layer cannot be effectively propagated to the electrodes. This reduces electromechanical conversion efficiency of the piezoelectric resonator, further increases dynamic impedance of the piezoelectric resonator, and degrades performance of the piezoelectric resonator.

Based on the foregoing problem, an embodiment of this application provides a piezoelectric resonator. Q of the piezoelectric resonator is high, and dynamic impedance of the piezoelectric resonator is small. In addition, a TCF turnover point of the piezoelectric resonator may be designed as required.

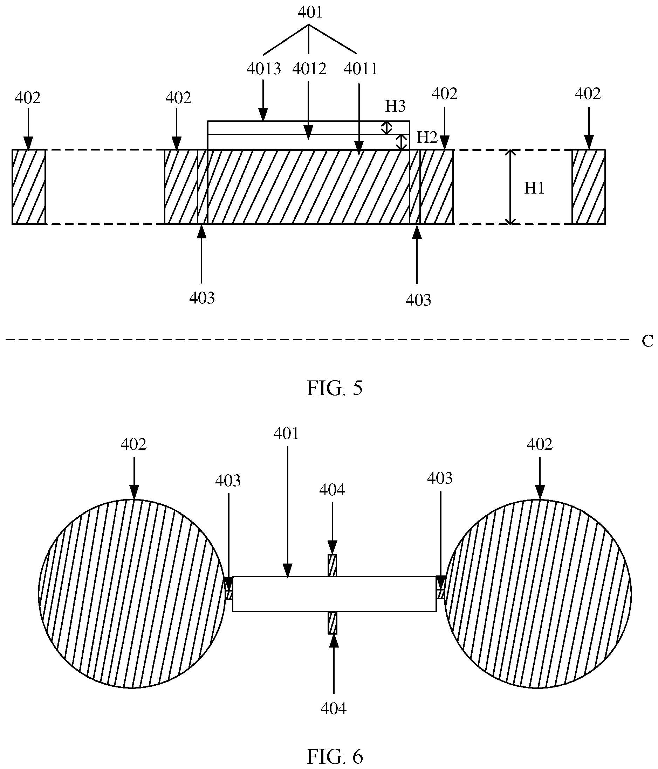

For example, FIG. 4 is a top view of a resonator according to an embodiment of this application, and FIG. 5 is a diagram of a cross section AA in FIG. 4. Refer to FIG. 4 and FIG. 5. The resonator includes a piezoelectric resonance part 401, a single crystal resonance part 402, and a coupling part 403.

The piezoelectric resonance part 401 includes a first electrode 4011, a piezoelectric layer 4012, and a second electrode 4013 that are sequentially stacked. When a drive signal is loaded between the first electrode 4011 and the second electrode 4013, the piezoelectric resonance part 401 can resonate under an action of the drive signal. A material of the piezoelectric layer 4012 may include but is not limited to aluminum nitride (AlN), scandium aluminum nitride (AlScN), lead zirconate titanate (PZT), lithium niobate (LiNbO3), and the like.

A material of the single crystal resonance part 402 is a single crystal material or a doped single crystal material. For example, the single crystal material may be single crystal silicon, and the doped single crystal material may be single crystal silicon whose doping concentration is greater than or equal to the 19$^{th}$ power of 10. It may be learned that the single crystal resonance part 402 is a component made of a single crystal material or a doped single crystal material. Generally, a resonance part that includes only a single crystal material or a doped single crystal material does not have problems such as a thermoelastic loss caused by material coefficient mismatch between a plurality of layers of materials. Therefore, an energy loss of the single crystal resonance part 402 is low.

The piezoelectric resonance part 401 and the single crystal resonance part 402 can resonate, and the piezoelectric resonance part 401 and the single crystal resonance part 402 are connected and coupled through the coupling part 403. Because the piezoelectric resonance part 401 and the single crystal resonance part 402 can be coupled through the coupling part 403, the single crystal resonance part 402 is in a vibration direction of the piezoelectric resonance part 401.

When the piezoelectric resonance part 401 can resonate under the action of the drive signal, the piezoelectric resonance part 401 can drive the single crystal resonance part 402 to resonate through the coupling part 403, thereby implementing resonance of the entire resonator. In addition, although Q (referred to as Q1) of the piezoelectric resonance part 401 is low, because Q (referred to as Q2) of the single crystal resonance part 402 is high, and Q (referred to as Qc) of the entire resonator satisfies the equation $\frac{1}{Q_c} \propto \frac{C_1}{Q_1} + \frac{C_2}{Q_2}$ (where C1 and C2 represent two constants greater than zero), Qc of the entire resonator is greater than Q1 of the piezoelectric resonance part 401, so that Q of the resonator can be increased.

In conclusion, in the resonator provided in this embodiment of this application, the material of the single crystal resonance part is a single crystal material or a doped single crystal material, and does not include another material. Therefore, Q of the single crystal resonance part is high. The piezoelectric resonance part is coupled to the single crystal resonance part, so that Q of the resonator including the piezoelectric resonance part and the single crystal resonance part is higher than Q of the piezoelectric resonance part. Therefore, Q of the resonator can be increased, an energy loss of the resonator can be reduced, and performance of the resonator can be improved.

The piezoelectric resonance part includes an electrode. The single crystal resonance part does not include an electrode. The piezoelectric resonance part and the single crystal resonance part are coupled through the coupling part. In this way, the electrode of the piezoelectric resonance part may be connected to a control circuit, the control circuit inputs a drive signal to the electrode of the piezoelectric resonance part, to drive the resonator to resonate. In addition, because electromechanical conversion efficiency of the piezoelectric resonance part is high, loading a drive signal on the piezoelectric resonance part can reduce dynamic impedance of the resonator compared with loading a drive signal on the single crystal resonance part.

Still refer to FIG. 4 and FIG. 5. The resonator may include two single crystal resonance parts 402 and two coupling parts 403 that are in one-to-one correspondence with the two single crystal resonance parts 402. The two single crystal resonance parts 402 are located on two opposite sides of the piezoelectric resonance part 401. The piezoelectric resonance part 401 and the single crystal resonance parts 402 are connected and coupled through the coupling parts 403 corresponding to the single crystal resonance parts 402. In this case, the two single crystal resonance parts 402 and the two coupling parts 403 are oppositely distributed on the two sides of the piezoelectric resonance part 401, so that the entire resonator has a symmetrical structure, thereby facilitating resonance of the resonator.

It should be noted that, in this embodiment of this application, an example in which the resonator includes the two single crystal resonance parts 402 and the two coupling parts 403 is used. Certainly, the resonator may include only one single crystal resonance part 402 and one coupling part 403, or the resonator may include more than two single crystal resonance parts 402 and more than two coupling parts 403. This is not limited in embodiments of this application.

The following separately describes the parts of the resonator.

(1) Single crystal resonance part 402

For the single crystal resonance part 402, a vibration mode of the single crystal resonance part 402 is not limited in embodiments of this application. For example, there are various vibration modes of the single crystal resonance part 402. For example, the vibration mode of the single crystal resonance part 402 is a breathing mode, a lame mode, an SE mode, an LE mode, a WE mode, or the like.

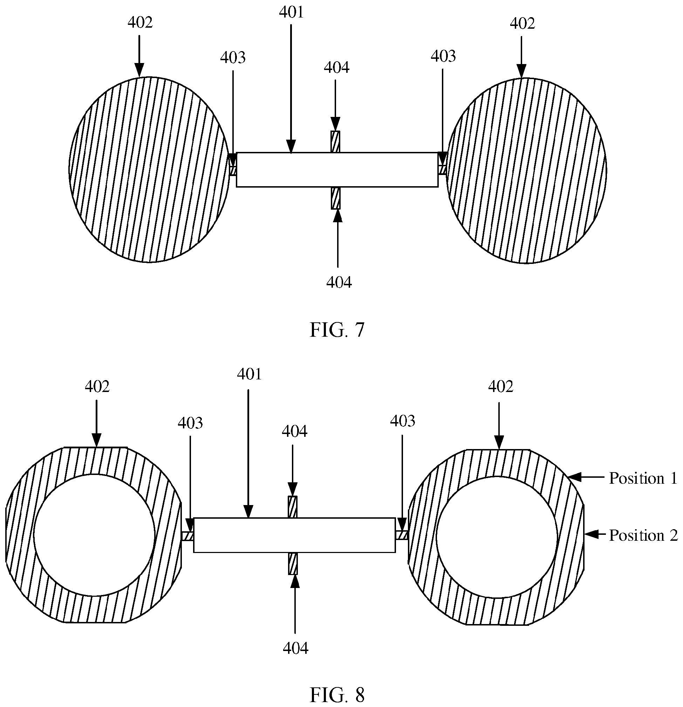

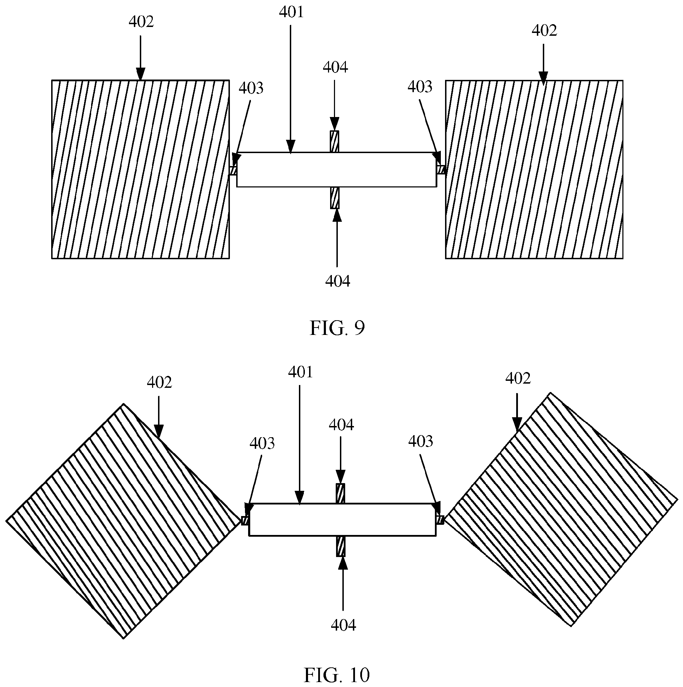

There may be various shapes of the single crystal resonance part 402. For example, an orthographic projection of the single crystal resonance part 402 on a reference plane C parallel to the piezoelectric layer 4012 of the piezoelectric resonance part 401 in FIG. 5 may be a ring (a regular ring shown in FIG. 4) having a curvature radius in an outer ring and having a curvature radius in an inner ring, a circle (as shown in FIG. 6), an ellipse (as shown in FIG. 7), a ring (as shown in FIG. 8) having a plurality of curvature radiuses in an outer ring, and a rectangle (a square shown in FIG. 9 and FIG. 10). An orthographic projection of an object on a reference plane indicates a projection formed on the reference plane when light perpendicular to the reference plane is irradiated to the reference plane from a side that is of the object and that is away from the reference plane.

When the orthographic projection is a ring having a plurality of curvature radiuses in an outer ring, the plurality of curvature radiuses may include two curvature radiuses, and positions having the two curvature radiuses in the outer ring may be alternately arranged. For example, the plurality of curvature radiuses may include two curvature radiuses, and the ring includes four first ring segments and four second ring segments. Some ring segments that belong to the outer ring and that are of the first ring segments have one curvature radius, some ring segments that belong to the outer ring and that are of the second ring segments have the other curvature radius, and the first ring segments and the second ring segments are alternately arranged.

Optionally, when the orthographic projection is a ring having a plurality of curvature radiuses in an outer ring, a curvature radius of each position in the outer ring may be negatively correlated with a ring width of the position. In this case, a curvature radius of a position with a large ring width in the outer ring is small, and a curvature radius of a position with a small ring width in the outer ring is large. As shown in FIG. 8, a ring width of a position 1 is greater than a ring width of a position 2, but a curvature radius of the position 1 is less than a curvature radius of the position 2. It should be noted that a portion at the position 2 in the outer ring may be a straight line or a curve. When the portion is a straight line, it may be considered that the curvature radius of the position 2 is infinite ($\infty$). When the orthographic projection of the single crystal resonance part 402 on the parallel reference plane C is a ring having a plurality of curvature radiuses in an outer ring, a shape of the ring may not be shown in FIG. 8. This is not limited in embodiments of this application. It may be understood that, when the orthographic projection is a ring having a plurality of curvature radiuses in an outer ring, a curvature radius of each position in the outer ring may alternatively not be negatively correlated with a ring width of the position. This is not limited in embodiments of this application either.

Optionally, when the orthographic projection is a ring having a plurality of curvature radiuses in an outer ring, an inner ring of the ring may have one curvature radius (is a circle, as shown in FIG. 8). Certainly, the inner ring of the ring may alternatively have a plurality of curvature radiuses. This is not limited in embodiments of this application.

Further, when the orthographic projection is an ellipse, a point with a large curvature radius (for example, a largest curvature radius) at an edge of the ellipse may be connected to the coupling part 403 at a corresponding position on the single crystal resonance part 402 (as shown in FIG. 7). When the orthographic projection is a ring having a plurality of curvature radiuses in an outer ring, a point with a large curvature radius in the outer ring may be connected to the coupling part 403 at a corresponding position on the single crystal resonance part 402 (as shown in FIG. 8). When the orthographic projection is a square, a position of a side (for example, a midpoint of the side) of the square may be connected to the coupling part 403 at a corresponding position on the single crystal resonance part 402 (as shown in FIG. 9), or a vertex angle of the square may be connected to the coupling part 403 at a corresponding position on the single crystal resonance part 402 (as shown in FIG. 10).

In a same vibration mode, there may be various shapes of the single crystal resonance part 402. For example, when the vibration mode of the single crystal resonance part 402 is a breathing mode, the shape of the single crystal resonance part 402 may be a ring (as shown in FIG. 4), a circle (as shown in FIG. 6), an ellipse (as shown in FIG. 7), an irregular circle, an irregular ellipse, an irregular ring (as shown in FIG. 8), or the like.

For another example, when the vibration mode of the single crystal resonance part 402 is a lame mode or an SE mode, the shape of the single crystal resonance part 402 may be a square.

When the vibration mode of the single crystal resonance part 402, the shape of the single crystal resonance part 402, and/or the quantity of single crystal resonance parts 402 change/changes, a TCF turnover point of the resonator changes, so that the resonator can support different TCF turnover points.

In addition, the single crystal resonance part 402 is connected to the coupling part 403, and any position that is in the single crystal resonance part 402 and that is not connected to the coupling part 403 may not be connected to any object.

(2) Piezoelectric resonance part 401

For the piezoelectric resonance part 401, a vibration mode of the piezoelectric resonance part 401 is an LE mode or a WE mode, or a vibration mode of the piezoelectric resonance part 401 may not be an LE mode or a WE mode. For example, the vibration mode of the piezoelectric resonance part 401 is a breathing mode, a lame mode, an SE mode, or the like.

A material of the piezoelectric resonance part 401 may include a single crystal material or a doped single crystal material. Still refer to FIG. 5. The piezoelectric resonance part 401 includes a first electrode 4011, a piezoelectric layer 4012, and a second electrode 4013. A material of at least one of the three layers may include a single crystal material or a doped single crystal material. For example, an example in which a material of the first electrode 4011 includes a single crystal material or a doped single crystal material is used in FIG. 5. When a portion of the resonator includes a single crystal material or a doped single crystal material, Q of the entire resonator is high. Therefore, when the material of the piezoelectric resonance part 401 includes a single crystal material or a doped single crystal material, Q of the piezoelectric resonance part 401 is high. In this way, Q of the entire resonator can be further increased.

A thickness of each film layer in the piezoelectric resonance part 401 is not limited in embodiments of this application. Optionally, as shown in FIG. 5, a thickness H1 of the first electrode 4011, a thickness H2 of the piezoelectric layer 4012, and a thickness H3 of the second electrode 4013 in the piezoelectric resonance part 401 are in a descending order. It may be learned through simulation calculation that, when the thickness H1 of the first electrode 4011, the thickness H2 of the piezoelectric layer 4012, and the thickness H3 of the second electrode 4013 are in the descending order, performance of the piezoelectric resonance part 401 is high, and performance of the entire resonance part is high. For example, the thickness H1 of the first electrode 4011 is greater than or equal to ten times the thickness H2 of the piezoelectric layer 4012 (this case is not shown in FIG. 5), and a range of the thickness H1 of the first electrode 4011 may be [10 micrometers, 100 micrometers].

It should be noted that, in this embodiment of this application, an example in which the piezoelectric resonance part 401 includes the first electrode 4011, the piezoelectric layer 4012, and the second electrode 4013 is used. Optionally, the piezoelectric resonance part 401 may further include another film layer. For example, the piezoelectric resonance part 401 further includes a substrate layer (not shown in the figure) located on a side that is of the first electrode 4011 and that is away from the piezoelectric layer 4012. In this case, the coupling part 403 may be connected to the substrate layer, the first electrode 4011, or the like.

(3) Coupling part 403

The coupling part 403 needs to connect and couple the piezoelectric resonance part 401 and the single crystal resonance part 402. To improve a coupling effect, the coupling part 403 may connect a point with strongest vibration of the piezoelectric resonance part 401 and a point with strongest vibration of the single crystal resonance part 402. For example, when the vibration mode of the piezoelectric resonance part 401 is an LE mode, an orthographic projection of the piezoelectric resonance part 401 on the reference plane is a rectangle, and the coupling part 403 may be connected to a shorter side of the rectangle. When the single crystal resonance part 402 is a regular ring, the coupling part 403 may be connected to any position of an outer side of the ring.

It may be learned from the foregoing content that, when a portion of the resonator includes a single crystal material or a doped single crystal material, Q of the entire resonator is high. Therefore, a material of the coupling part 403 in this embodiment of this application may also include a single crystal material or a doped single crystal material. In this way, Q of the resonator is further increased. In this embodiment of this application, an example in which the coupling part 403 includes only a single crystal material or a doped single crystal material is used. Optionally, the material of the coupling part 403 may also include a material in addition to the single crystal material or the doped single crystal material, or the material of the coupling part 403 may not include the single crystal material or the doped single crystal material.

For the piezoelectric resonance part 401, the single crystal resonance part 402, and the coupling part 403 of the resonator, the first electrode 4011, the coupling part 403, and the single crystal resonance part 402 may be made of a same material and may have a same thickness (as shown in FIG. 5). In this case, the first electrode 4011, the coupling part 403, and the single crystal resonance part 402 may be simultaneously prepared on a same material layer. Certainly, the first electrode 4011, the coupling part 403, and the single crystal resonance part 402 may alternatively be made of different materials and have different thicknesses. This is not limited in embodiments of this application.

Shapes of the piezoelectric resonance part 401, the single crystal resonance part 402, and the coupling part 403 are not limited in embodiments of this application. For example, refer to FIG. 4 and FIG. 5. Both a first orthographic projection of the piezoelectric resonance part 401 on a reference plane C parallel to the piezoelectric layer 4012 and a second orthographic projection of the coupling part 403 on the reference plane C are strips, and a third orthographic projection of the single crystal resonance part 402 on the reference plane C is a ring. In addition, a width W1 of the first orthographic projection, a maximum ring width W2 of the third orthographic projection, and a width W3 of the second orthographic projection are in a descending order. It may be learned through simulation calculation that, when the width W1 of the first orthographic projection, the ring width W2 of the third orthographic projection, and the width W3 of the second orthographic projection are in the descending order, performance of the resonator is high. For example, the width W1 of the first orthographic projection is greater than or equal to twice the ring width W3 of the third orthographic projection (this case is not shown in FIG. 5). A range of the width of the first orthographic projection may be [10 micrometers, 300 micrometers].

An orthographic projection of the piezoelectric resonance part 401 on the reference plane C is located outside an orthographic projection of the single crystal resonance part 402 on the reference plane C. Certainly, the orthographic projection of the piezoelectric resonance part 401 on the reference plane C and the orthographic projection of the single crystal resonance part 402 on the reference plane C may alternatively overlap. For example, the piezoelectric layer 4012 and the second electrode 4013 extend to the single crystal resonance part 402.

Further, still refer to FIG. 4 and FIG. 5. The resonator provided in this embodiment of this application further includes an anchoring part 404 (also referred to as an anchor). The anchoring part 404 is connected to a vibration node (a position with a smallest amplitude of the piezoelectric resonance part 401) of the piezoelectric resonance part 401, and is spaced from the single crystal resonance part 402. The anchoring part 404 is configured to anchor a portion of the resonator other than the anchoring part 404. It may be learned that, in this embodiment of this application, the portion of the resonator other than the anchoring part 404 is anchored on the piezoelectric resonance part 401. Certainly, the anchoring part 404 may alternatively be connected to a vibration node (a position with a smallest amplitude of the single crystal resonance part 402) of the single crystal resonance part 402. Compared with the connection between the anchoring part 404 and the single crystal resonance part 402, the connection between the anchoring part 404 and the piezoelectric resonance part 401 brings a smaller decrement of Q of the resonator, thereby ensuring that Q of the resonator is higher. In addition, when the anchoring part 404 is connected to the vibration node of the piezoelectric resonance part 401, or when the anchoring part 404 is connected to the vibration node of the single crystal resonance part 402, an energy loss on the anchoring part 404 is low, and an energy loss caused by the anchoring part 404 to the resonator is low.

It may be learned from the foregoing content that the piezoelectric resonance part 401 includes a plurality of layers of structures, and the anchoring part 404 needs to be connected to the piezoelectric resonance part 401. In this case, the anchoring part 404 may be connected to one layer of structure (for example, the first electrode 4011 in FIG. 4 and FIG. 5) or at least two layers of structures (for example, each layer of structure) in the piezoelectric resonance part 401. Optionally, the anchoring part 404 may be a strip (in this case, the anchoring part 401 may be referred to as a support beam), and one end of the anchoring part 404 in a length direction is connected to the piezoelectric resonance part 401.

Still refer to FIG. 4 and FIG. 5. The resonator may include two groups of anchoring parts 404 located on two opposite sides of the piezoelectric resonance part 401. Each group of anchoring parts 404 includes one anchoring part 404. Optionally, each group of anchoring parts 404 may alternatively include a plurality of anchoring parts 404. Alternatively, the resonator may include one group of anchoring parts 404 located on a side of the piezoelectric resonance part 401. This is not limited in embodiments of this application.

Optionally, as shown in FIG. 4, a first arrangement direction P1 of the piezoelectric resonance part 401 and the single crystal resonance part 402 is different from a second arrangement direction P2 of the piezoelectric resonance part 402 and the anchoring part 404. Both the first arrangement direction P1 and the second arrangement direction P2 are parallel to the piezoelectric layer 4012. As shown in FIG. 4, the piezoelectric layer 4012 is parallel to the paper. The first arrangement direction P1 is a left-right direction parallel to the paper, and the second arrangement direction P2 is an up-down direction parallel to the paper. In this embodiment of this application, an example in which the first arrangement direction P1 is perpendicular to the second arrangement direction P2 is used. Optionally, the first arrangement direction P1 may alternatively not be perpendicular to the second arrangement direction P2. This is not limited in embodiments of this application.

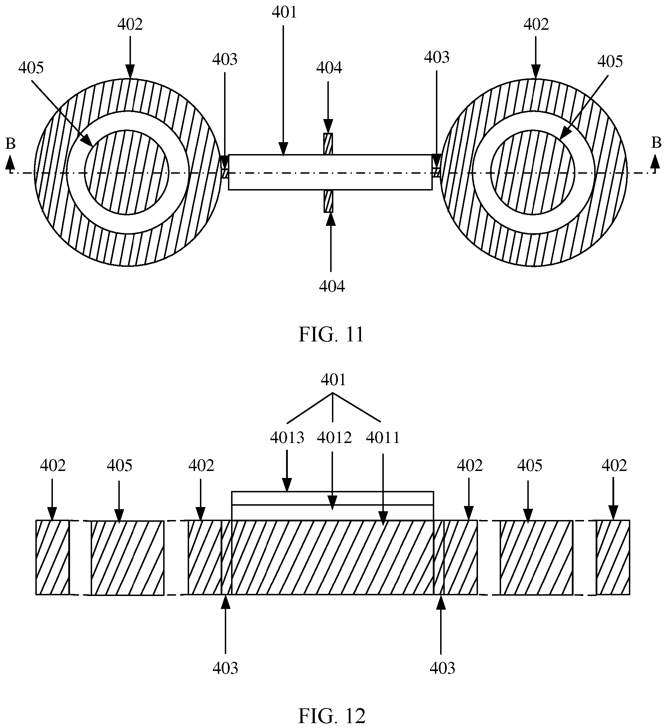

Further, FIG. 11 is a top view of another resonator according to an embodiment of this application, and FIG. 12 is a diagram of a cross section BB in FIG. 11. As shown in FIG. 11 and FIG. 12, based on FIG. 4 and FIG. 5, the resonator may further include an auxiliary electrode 405 corresponding to the single crystal resonance part 402, and a gap exists between the auxiliary electrode 405 and the single crystal resonance part 402. In this case, a material of the single crystal resonance part may be any material, for example, a single crystal material, a doped single crystal material, a polycrystalline material, or a doped polycrystalline material.

It should be noted that, if the resonator includes a plurality of single crystal resonance parts 402, the resonator may include a plurality of auxiliary electrodes 405 that are in one-to-one correspondence with the plurality of single crystal resonance parts 402, a gap exists between each auxiliary electrode 405 and a corresponding single crystal resonance part 402, the gap between the auxiliary electrode 405 and the corresponding single crystal resonance part 402 is less than a gap between the auxiliary electrode 405 and another single crystal resonance part 402, and the another single crystal resonance part 402 is any single crystal resonance part 402 of the plurality of single crystal resonance parts 402 other than the single crystal resonance part 402 corresponding to the auxiliary electrode 405.

Optionally, a maximum gap between the auxiliary electrode 405 and the corresponding single crystal resonance part 402 is less than 2 micrometers. A position relationship between the single crystal resonance part 402 and the corresponding auxiliary electrode 405 may be any position relationship. For example, in this embodiment of this application, an example in which the single crystal resonance part 402 is a ring surrounding the corresponding auxiliary electrode 405 is used.

A material of the auxiliary electrode 405 is a conductive material. Optionally, the material of the auxiliary electrode 405 may be the same as the material of the single crystal resonance part 402, and the auxiliary electrode 405 and the single crystal resonance part 402 are located at a same layer. In this way, a same material layer may be processed, to simultaneously prepare the auxiliary electrode 405 and the single crystal resonance part 402. In this embodiment of this application, the first electrode 4011 of the piezoelectric resonance part 401, the single crystal resonance part 402, the coupling part 403, and the auxiliary electrode 405 are all made of a same material. Therefore, a same material layer may be processed, to simultaneously prepare the first electrode 4011, the single crystal resonance part 402, the coupling part 403, and the auxiliary electrode 405.

It should be noted that, in this embodiment of this application, an example in which the resonator shown in FIG. 4 and FIG. 5 further includes the auxiliary electrode is used. Optionally, another resonator (the resonator shown in FIG. 6, FIG. 7, or the like) provided in an embodiment of this application may also include an auxiliary electrode.

Because the resonator includes the auxiliary electrode 405, the auxiliary electrode 405 may be connected to the control circuit (not shown in FIG. 11 and FIG. 12), so that the control circuit may provide a drive signal for the resonator through a first electrode group including the auxiliary electrode 405, to drive the resonator to resonate and generate a vibration signal. For example, the first electrode group includes the first electrode 4011, the second electrode 4013, and the auxiliary electrode 405; or the first electrode group includes the first electrode 4011 and the auxiliary electrode 405. Optionally, the first electrode group may not include the auxiliary electrode 405. For example, the first electrode group includes the first electrode 4011 and the second electrode 4013. For example, when the resonator does not include the auxiliary electrode 405, the control circuit may provide the drive signal for the resonator through the first electrode 4011 and the second electrode 4013, and receive the vibration signal.

When the resonator includes the auxiliary electrode 405, the control circuit may further receive, through a second electrode group including the auxiliary electrode 405, a vibration signal generated by resonance of the resonator. For example, the second electrode group includes the first electrode 4011, the second electrode 4013, and the auxiliary electrode 405; or the second electrode group includes the first electrode 4011 and the auxiliary electrode 405. Optionally, the second electrode group may not include the auxiliary electrode 405. For example, the second electrode group includes the first electrode 4011 and the second electrode 4013. For example, when the resonator does not include the auxiliary electrode 405, the control circuit may receive, through the first electrode 4011 and the second electrode 4013, the vibration signal generated by the resonator.

The first electrode group and the second electrode group may be the same or may be different. This is not limited in embodiments of this application. When the second electrode group includes the first electrode 4011, the second electrode 4013, and the auxiliary electrode 405, the control circuit is configured to receive, through the auxiliary electrode 405, the first electrode 4011, and the second electrode 4013, a vibration signal generated by resonance of the resonator. Because a large quantity of electrodes are used by the control circuit to receive the vibration signal, an area of the electrodes for receiving the vibration signal can be increased, a current of the vibration signal received by the control circuit can be increased, and dynamic impedance of the resonator can be reduced.

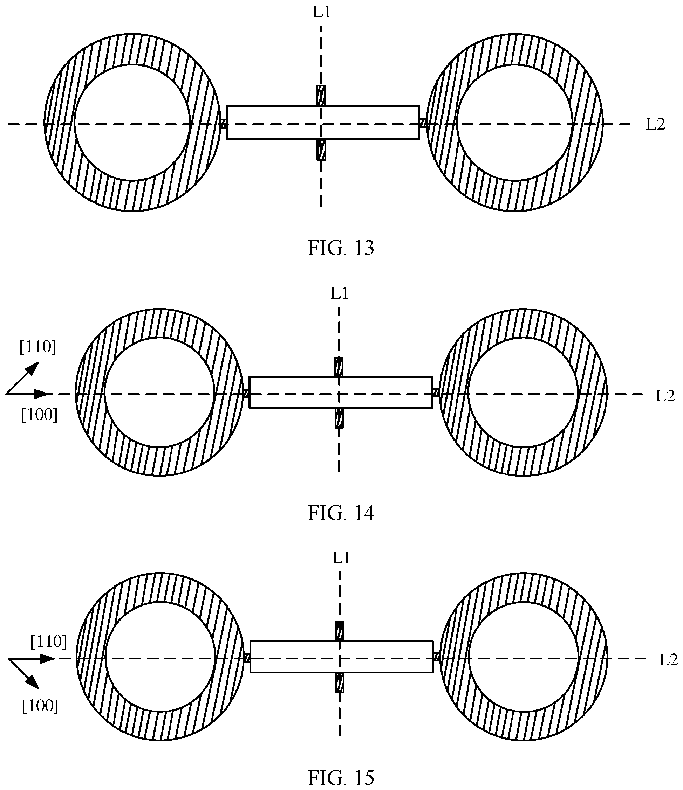

Further, various resonators provided in embodiments of this application may have a symmetrical structure. For example, an orthographic projection of the resonator shown in FIG. 4 on the reference plane C parallel to the piezoelectric layer 4012 in FIG. 5 may be shown in FIG. 13, and the orthographic projection is an axial symmetric figure. The axial symmetric figure has a first symmetry axis L1 that passes through an orthographic projection of the anchoring part 404 on the reference plane C, and/or the axial symmetric figure has a second symmetry axis L2 that passes through the orthographic projection of the single crystal resonance part 402 on the reference plane C. In this embodiment of this application, an example in which the axial symmetric figure has both the first symmetry axis L1 and the second symmetry axis L2 is used.

For example, the resonator includes two anchoring parts 404 distributed on two opposite sides of the piezoelectric resonance part 401, orthographic projections of the anchoring parts 404 on the reference plane C are rectangles, and the first symmetry axis L1 may pass through a central axis of the orthographic projections of the two anchoring parts 404 on the reference plane C. The resonator includes two single crystal resonance parts 402 located on two opposite sides of the piezoelectric resonance part 401, orthographic projections of the single crystal resonance part 402 on the reference plane C are rings, and the second symmetry axis L2 may pass through centers of the orthographic projections of the two single crystal resonance parts 402 on the reference plane C.

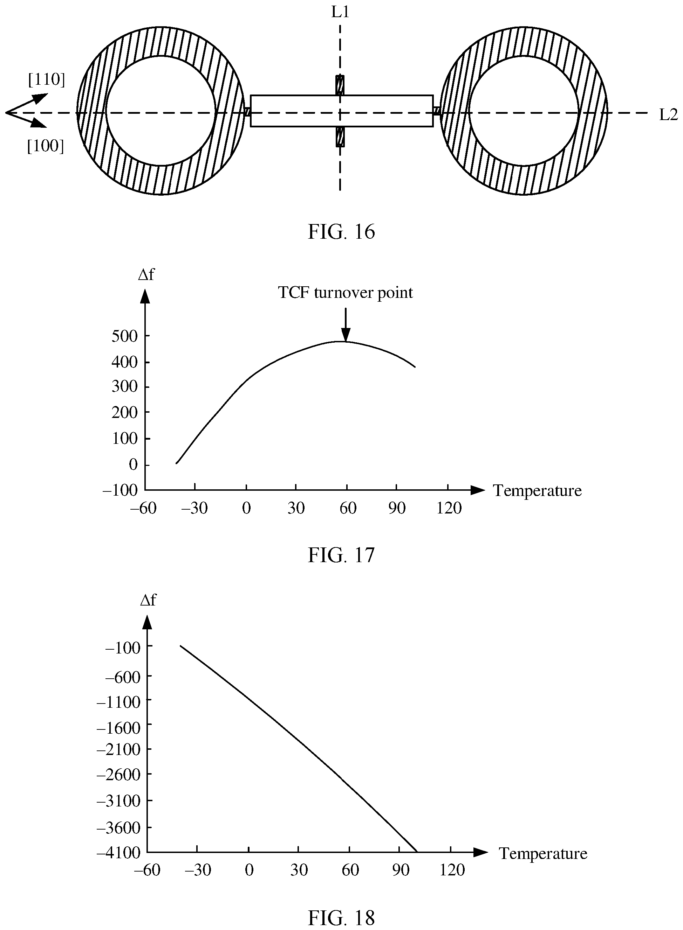

Optionally, an extension direction of the second symmetry axis L2 may have a specific relationship with a crystal direction of the single crystal resonance part 402. For example, as shown in FIG. 14, the extension direction of the second symmetry axis L2 is a crystal direction [100] of the single crystal resonance part 402; as shown in FIG. 15, the extension direction of the second symmetry axis L2 is a crystal direction [110] of the single crystal resonance part 402; or as shown in FIG. 16, the extension direction of the second symmetry axis L2 is between a crystal direction [100] and a crystal direction [110] of the single crystal resonance part 402. In this case, an included angle between the extension direction of the second symmetry axis L2 and the crystal direction [110] of the single crystal resonance part 402 is greater than 0 degrees and less than 45 degrees.

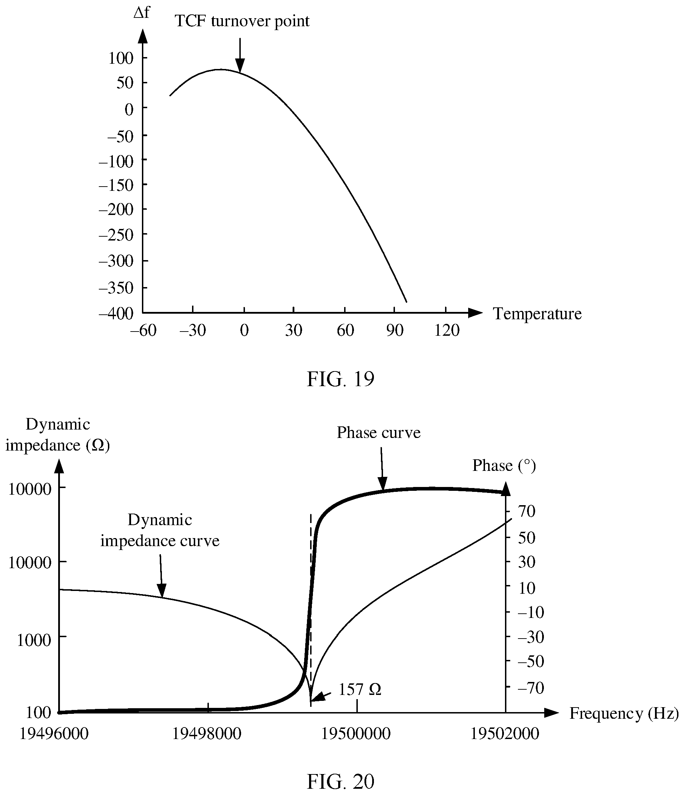

It may be learned that, in this embodiment of this application, there may be a plurality of extension directions of the second symmetry axis L2. In addition, when the second symmetry axis L2 extends in different extension directions, the resonator has different TCF turnover points, so that the resonator can support different TCF turnover points. For example, when the extension direction of the second symmetry axis L2 shown in FIG. 14 is the crystal direction [100] of the single crystal resonance part 402, a diagram of a TCF curve of the resonator is shown in FIG. 17, and a temperature of a TCF turnover point of the resonator is approximately 60°C. When the extension direction of the second symmetry axis L2 shown in FIG. 15 is the crystal direction [110] of the single crystal resonance part 402, a diagram of a TCF curve of the resonator is shown in FIG. 18, and a temperature of a TCF turnover point of the resonator is less than -40°C (the TCF turnover point is not shown in FIG. 18). When the extension direction of the second symmetry axis L2 shown in FIG. 16 is between the crystal direction [100] and the crystal direction [110] of the single crystal resonance part 402, and the included angle between the extension direction of the second symmetry axis L2 and the crystal direction [110] is 22.5 degrees, a diagram of a TCF curve of the resonator is shown in FIG. 19, and a temperature of a TCF turnover point of the resonator is approximately 0°C.

The resonator provided in this embodiment of this application may be manufactured by using an MEMS technology. Therefore, the resonator may also be referred to as an MEMS resonator. Certainly, the resonator may alternatively not be manufactured by using the MEMS technology. This is not limited in embodiments of this application.

Optionally, when the resonator provided in this embodiment of this application includes the anchoring part 404, the anchoring part 404 may be fastened to a substrate (not shown in the figure), and a gap exists between the portion of the resonator other than the anchoring part 404 and the substrate, to support resonance of the resonator.

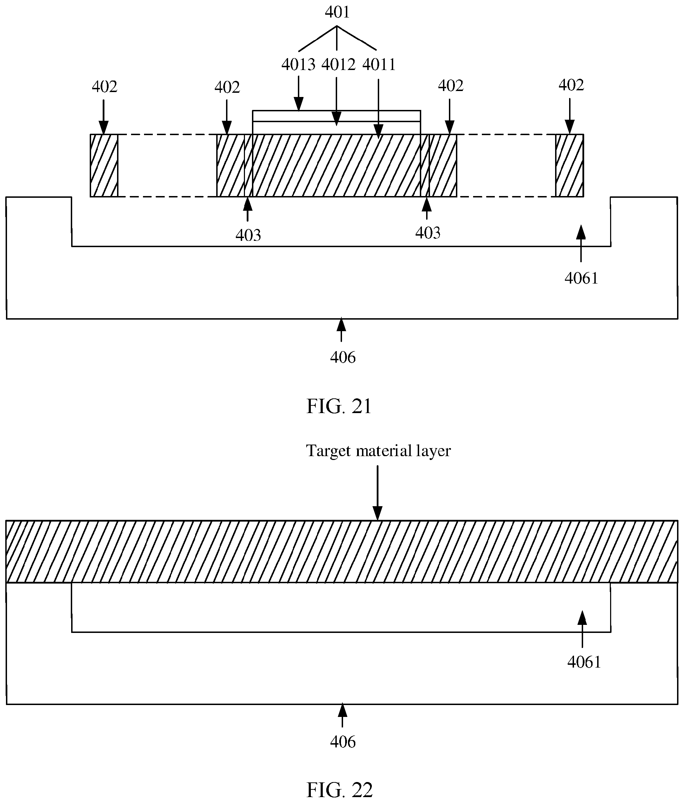

For example, as shown in FIG. 21, based on FIG. 5, the resonator further includes a substrate 406, the substrate 406 is provided with a groove 4061, a portion of the resonator other than the substrate 406 is located at an opening of the groove 4061, the anchoring part (not shown in FIG. 21) of the resonator is connected (for example, bonded) to a position outside the opening of the groove 4061 in the substrate 406, and the portion of the resonator other than the anchoring part is not in contact with the substrate 406. When the resonator shown in FIG. 21 is manufactured, the substrate 406 with the groove 4061 shown in FIG. 22 may be first manufactured, the substrate 406 is covered with a target material layer, and the target material layer is bonded to the substrate 406. In this case, the target material layer is not in contact with neither a side surface nor a bottom surface of the groove 4061. Then, the target material layer is processed to obtain the first electrode 4011, the single crystal resonance part 402, the coupling part 403, and the anchoring part in FIG. 21. Then, the piezoelectric layer 4012 and the second electrode 4013 are formed in sequence. It should be noted that an example in which the first electrode 4011, the single crystal resonance part 402, the coupling part 403, and the anchoring part are located at a same layer and made of a same material is used herein. If the first electrode 4011, the single crystal resonance part 402, the coupling part 403, and the anchoring part are not located at a same layer and/or are made of different materials, the resonator may be manufactured in another manner. Details are not described herein in embodiments of this application.

Further, when the resonator provided in this embodiment of this application includes the auxiliary electrode 405, the auxiliary electrode 405 may be fastened at a position, and a gap exists between the auxiliary electrode 405 and the corresponding single crystal resonance part 402. For example, the auxiliary electrode 405 may alternatively be fastened to the substrate on which the anchoring part 404 is located.

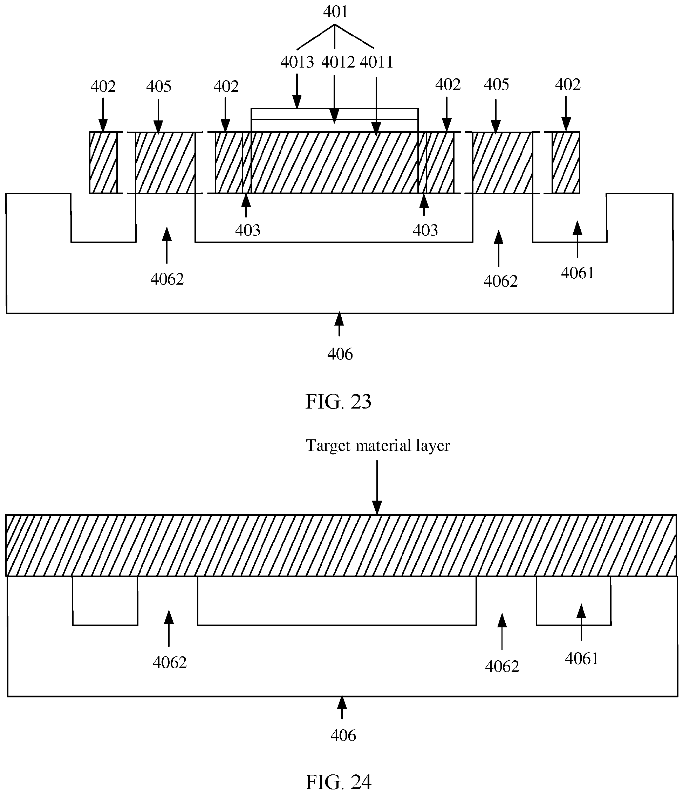

For example, as shown in FIG. 23, based on FIG. 21, the bottom surface of the groove 4061 is provided with a protrusion 4062 corresponding to the auxiliary electrode 405, and the auxiliary electrode 405 in the resonator is connected (for example, bonded) to the corresponding protrusion 4062. When the resonator is manufactured, as shown in FIG. 24, the substrate 406 shown in FIG. 23 including the groove 4061 and the protrusion 4062 may be first manufactured, the substrate 406 is covered with a target material layer, and the target material layer is bonded to the substrate 406. In this case, based on FIG. 22, the target material layer is in contact with the protrusion 4062. Then, the target material layer is processed to obtain the first electrode 4011, the single crystal resonance part 402, the coupling part 403, the anchoring part, and the auxiliary electrode 405 in FIG. 23. Then, the piezoelectric layer 4012 and the second electrode 4013 are formed in sequence. It should be noted that an example in which the first electrode 4011, the single crystal resonance part 402, the coupling part 403, the anchoring part, and the auxiliary electrode 405 are located at a same layer and made of a same material is used herein. If the first electrode 4011, the single crystal resonance part 402, the coupling part 403, the anchoring part, and the auxiliary electrode 405 are not located at a same layer and/or are made of different materials, the resonator may be manufactured in another manner. Details are not described herein in embodiments of this application.

In conclusion, in the resonator provided in this embodiment of this application, the material of the single crystal resonance part is a single crystal material or a doped single crystal material, and does not include another material. Therefore, Q of the single crystal resonance part is high. The piezoelectric resonance part is coupled to the single crystal resonance part, so that Q of the resonator including the piezoelectric resonance part and the single crystal resonance part is higher than Q of the piezoelectric resonance part. Therefore, Q of the resonator can be increased, an energy loss of the resonator can be reduced, and performance of the resonator can be improved. It may be learned through simulation calculation that Q of the piezoelectric resonator is generally approximately 230,000, and Q of the resonator provided in this embodiment of this application may reach approximately 504,000. It may be learned that Q of the resonator provided in this embodiment of this application is greatly increased compared with Q of the piezoelectric resonator.

The piezoelectric resonance part includes an electrode. The single crystal resonance part does not include an electrode. The piezoelectric resonance part and the single crystal resonance part are coupled through the coupling part. In this way, the electrode of the piezoelectric resonance part may be connected to the control circuit, and the control circuit inputs the drive signal to the electrode of the piezoelectric resonance part, to drive the resonator to resonate. In addition, because electromechanical conversion efficiency of the piezoelectric resonance part is high, loading a drive signal on the piezoelectric resonance part can reduce dynamic impedance of the resonator compared with loading a drive signal on the single crystal resonance part. For example, FIG. 20 is a diagram of a dynamic impedance curve and a phase curve of a resonator according to an embodiment of this application. It may be learned from FIG. 20 that dynamic impedance of the resonator provided in this embodiment of this application is 157 ohms (Ω), and the dynamic impedance is small.

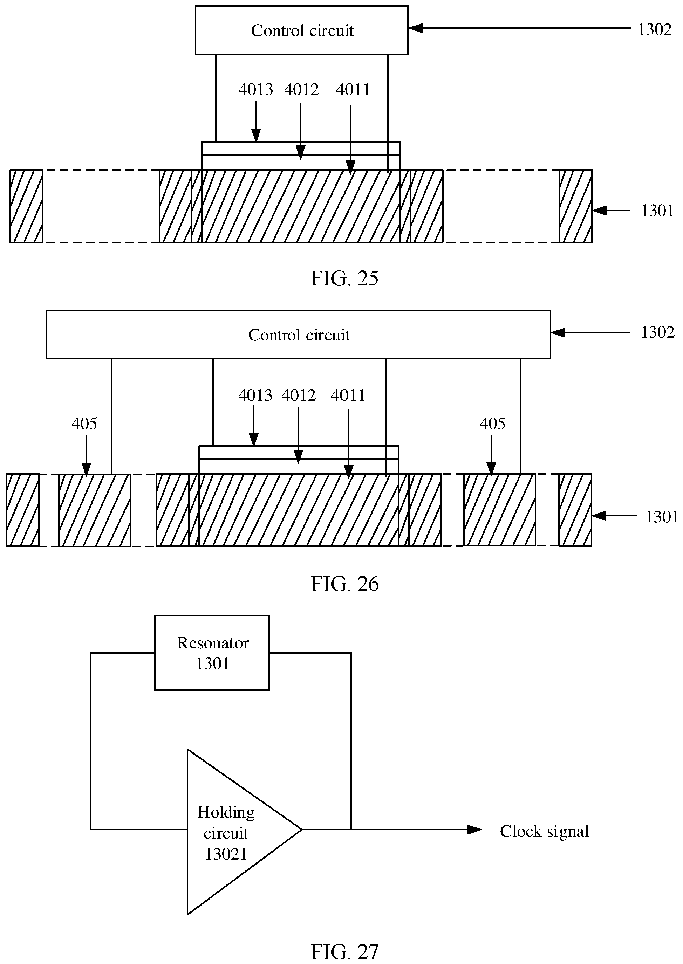

Based on the resonator provided in embodiments of this application, an embodiment of this application further provides a resonant system. As shown in FIG. 25, the resonant system includes any resonator 1301 (the resonator shown in FIG. 4 is used as an example in FIG. 25) provided in embodiments of this application and a control circuit 1302. The control circuit 1302 is configured to provide a drive signal for the resonator 1301, and receive a vibration signal generated by resonance of the resonator 1301.

For example, the control circuit 1302 may provide a drive signal for the resonator 1301 through a connected first electrode group, to drive the resonator 1301 to resonate and generate a vibration signal. The control circuit 1302 may further receive the vibration signal through a connected second electrode group. For one electrode group of the first electrode group and the second electrode group, the electrode group includes a first electrode and a second electrode. Alternatively, the resonator includes an auxiliary electrode corresponding to the single crystal resonance part, and the electrode group includes a first electrode, a second electrode, and the auxiliary electrode. Alternatively, the resonator includes an auxiliary electrode, and the electrode group includes a first electrode and the auxiliary electrode. The first electrode group and the second electrode group may be the same or may be different. This is not limited in embodiments of this application.

For example, as shown in FIG. 25, an example in which the first electrode group includes a first electrode 4011 and a second electrode 4013, and the second electrode group includes a first electrode 4011, a second electrode 4013, and an auxiliary electrode 405 is used. The control circuit 1302 is configured to provide a drive signal for the resonator 1301 through the first electrode 4011 and the second electrode 4013, to drive the resonator 1301 to resonate and generate a vibration signal. It may be learned that the control circuit 1302 may drive, by using the first electrode 4011 and the second electrode 4013, the piezoelectric resonance part 401 to resonate, and then the piezoelectric resonance part 401 drives, by using the coupling part 403, the single crystal resonance part to resonate, so that the entire resonator resonates. In this case, the control circuit 1302 does not need to drive the single crystal resonance part to resonate. In addition, as shown in FIG. 25, an example in which the second electrode group includes a first electrode 4011 and a second electrode 4013 is used. In this case, the control circuit 1302 provides a drive signal for the resonator 1301 through the first electrode 4011 and the second electrode 4013, and also receives, through the two electrodes, a vibration signal generated by resonance of the resonator 1301.

For another example, as shown in FIG. 26, based on FIG. 25, the resonator 1301 further includes the auxiliary electrode 405 corresponding to the single crystal resonance part 402. The control circuit 1302 is further connected to the auxiliary electrode 405. The first electrode group includes the first electrode 4011 and the second electrode 4013. The second electrode group includes the first electrode 4011, the second electrode 4013, and the auxiliary electrode 405. In this case, the control circuit 1302 provides a drive signal for the resonator 1301 through the first electrode 4011 and the second electrode 4013, and receives, through the first electrode 4011, the second electrode 4013, and the auxiliary electrode 405, a vibration signal generated by resonance of the resonator 1301. When the control circuit 1302 is configured to receive, through the auxiliary electrode 405, the first electrode 4011, and the second electrode 4013, the vibration signal generated by resonance of the resonator 1301, because a large quantity of electrodes are used by the control circuit 1302 to receive the vibration signal, an area of the electrodes for receiving the vibration signal can be increased, a current of the vibration signal received by the control circuit 1302 can be increased, and dynamic impedance of the resonator 1301 can be reduced.

The resonant system provided in this embodiment of this application may be any system including a resonator and a control circuit, for example, an oscillator (also referred to as a clock generator), a sensor, a communication device (for example, a wireless communication device), or a wearable device. For example, as shown in FIG. 27, when the resonant system is an oscillator, the oscillator may include a resonator 1301 and a control circuit 1302 connected to the resonator 1301. The control circuit 1302 includes a holding circuit 13021 configured to generate the drive signal, and other circuits (not shown in FIG. 27). The oscillator can output a vibration signal generated by resonance of the resonator, and the vibration signal may be used as a clock signal.

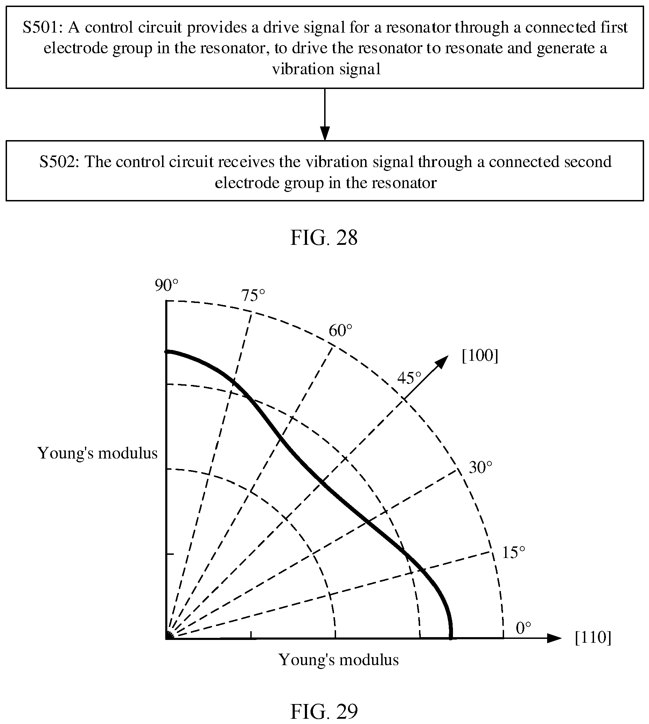

Based on the resonant system provided in this embodiment of this application, an embodiment of this application provides a signal obtaining method for the control circuit in the resonant system. As shown in FIG. 28, the method includes the following steps.

S501: The control circuit provides a drive signal for the resonator through a connected first electrode group in the resonator, to drive the resonator to resonate and generate a vibration signal.

S502: The control circuit receives the vibration signal through a connected second electrode group in the resonator.

For one electrode group of the first electrode group and the second electrode group, the electrode group includes a first electrode and a second electrode. Alternatively, the resonator includes an auxiliary electrode corresponding to the single crystal resonance part, and the electrode group includes a first electrode, a second electrode, and the auxiliary electrode. Alternatively, the resonator includes an auxiliary electrode, and the electrode group includes a first electrode and the auxiliary electrode. The first electrode group and the second electrode group may be the same or may be different. This is not limited in embodiments of this application.

When the second electrode group includes the first electrode, the second electrode, and the auxiliary electrode, the control circuit receives, through the three types of electrodes, a vibration signal generated by resonance of the resonator. In this case, because a large quantity of electrodes are used by the control circuit to receive the vibration signal, an area of the electrodes for receiving the vibration signal can be increased, a current of the vibration signal received by the control circuit can be increased, and dynamic impedance of the resonator can be reduced.

It may be learned from the foregoing analysis that the resonator generates a thermoelastic loss in a vibration process. The thermoelastic loss is an important energy consumption mechanism of the resonator. The thermoelastic loss limits Q corresponding to the thermoelastic loss, thereby limiting a Q value of the resonator, so that Q value of the resonator is low, and performance of the resonator is limited. For example, when the resonator is used as a clock oscillator, a low Q value increases phase noise of a clock signal output by the clock oscillator. When the resonator is used as a sensor, a lower Q value reduces precision of the sensor.

The mechanism for generating the thermoelastic loss is as follows: A resonant layer used for vibration in the resonator has anisotropy, and stiffnesses of target crystal directions of the resonant layer are different. Consequently, vibration amplitudes of the target crystal directions of the resonant layer are different, and amounts of heat generated in the target crystal directions of the resonant layer are different. In this way, the amounts of heat generated in the target crystal directions of the resonant layer are different, and a heat gradient is generated. The heat gradient causes heat flow, resulting in an irreversible energy loss. The loss is referred to as the thermoelastic loss.

In a conventional technology, holes and grooves may be etched in the resonance layer to reduce heat flow and reduce the thermoelastic loss of the resonator. However, this solution is applicable only to a resonator in a bending mode and with a quite high thermoelastic loss. For a resonator in a body mode and with a low thermoelastic loss, digging a groove increases a local stress concentration degree of the resonator, thereby increasing a heat gradient and increasing the thermoelastic loss. It may be learned that the manner of etching holes and grooves is not applicable to the resonator in the body mode and with the low thermoelastic loss.

An embodiment of this application provides a resonator. The resonator has a low thermoelastic loss.

Therefore, the resonator has a high Q value, and performance of the resonator is high. In addition, the resonator may be a resonator in a bending mode or a resonator in a body mold.

The resonator provided in this embodiment of this application includes an electrostatic resonance layer. A material of the electrostatic resonance layer may be a single crystal material, a polycrystalline material, a doped single crystal material, a doped polycrystalline material, or the like. For example, the material of the electrostatic resonance layer is single crystal silicon, polycrystalline silicon, silicon carbide, single crystal aluminum nitride, polycrystalline aluminum nitride, or the like.

The electrostatic resonance layer has a plurality of target crystal directions parallel to the electrostatic resonance layer, Young's moduli of the electrostatic resonance layer in different target crystal directions are different. The electrostatic resonance layer has anisotropy. In addition, a length of the electrostatic resonance layer on a straight line parallel to any target crystal direction is negatively correlated with a Young's modulus of the electrostatic resonance layer in the any target crystal direction. The straight line passes through a center of the electrostatic resonance layer, and is parallel to the electrostatic resonance layer. A length of the electrostatic resonance layer on a straight line is a length of a portion that intersects the electrostatic resonance layer and that is of the straight line.

For example, it is assumed that a first target crystal direction and a second target crystal direction are any two target crystal directions of the electrostatic resonance layer. When a Young's modulus of the electrostatic resonance layer in the first target crystal direction is greater than a Young's modulus of the electrostatic resonance layer in the second target crystal direction, a length of the electrostatic resonance layer on a straight line (passing through a center of the electrostatic resonance layer) parallel to the first target crystal direction is less than a length of the electrostatic resonance layer on a straight line (passing through the center of the electrostatic resonance layer) parallel to the second target crystal direction. When a Young's modulus of the electrostatic resonance layer in the first target crystal direction is less than a Young's modulus of the electrostatic resonance layer in the second target crystal direction, a length of the electrostatic resonance layer on a straight line (passing through a center of the electrostatic resonance layer) parallel to the first target crystal direction is greater than a length of the electrostatic resonance layer on a straight line (passing through the center of the electrostatic resonance layer) parallel to the second target crystal direction.

It is assumed that Young's moduli of the electrostatic resonance layer in some target crystal directions may be shown in FIG. 29. Both a horizontal axis and a vertical axis in FIG. 29 represent Young's moduli, and an angle in FIG. 29 represents an included angle between a target crystal direction and a crystal direction [110]. It may be learned from FIG. 29 that a Young's modulus of the electrostatic resonance layer in a crystal direction [100] is low, and a Young's modulus of the electrostatic resonance layer in the crystal direction [110] is high. Based on the Young's moduli shown in FIG. 29, the electrostatic resonance layer may be implemented in the following two implementations.

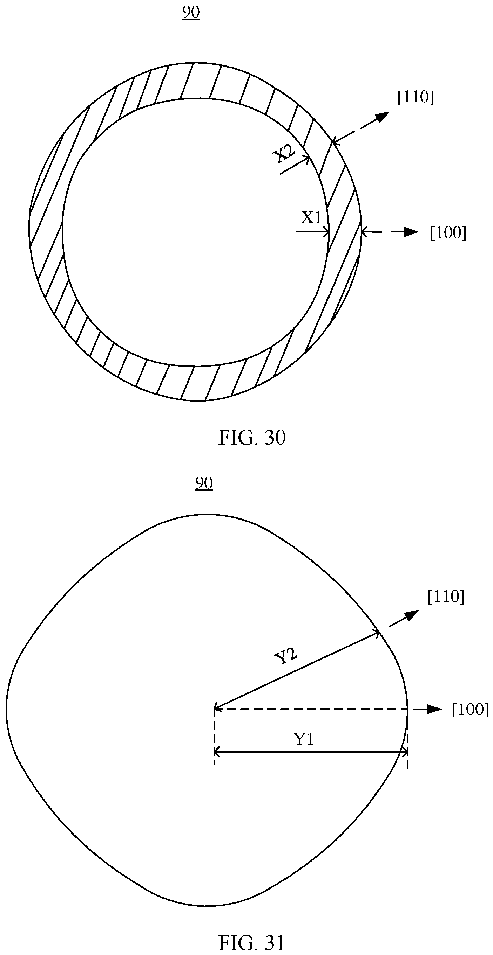

In a first implementation, a structure of the electrostatic resonance layer may be shown in FIG. 30. The electrostatic resonance layer 90 may be a ring, and curvature of each position in an inner ring and an outer ring of the ring is greater than zero. A length (ring width) X1 of the electrostatic resonance layer 90 on a straight line (passing through the center of the electrostatic resonance layer) parallel to the crystal direction [100] is greater than a length (ring width) X2 of the electrostatic resonance layer 90 on a straight line (passing through the center of the electrostatic resonance layer) parallel to the crystal direction [110]. It may be learned that the electrostatic resonance layer 90 shown in FIG. 30 is a ring with unequal ring widths. In addition, the center of the electrostatic resonance layer 90 is located in a hollow-out area surrounded by the inner ring of the ring.

In a second implementation, a structure of the electrostatic resonance layer may alternatively be shown in FIG. 31. The electrostatic resonance layer 90 is a convex shape, and curvature of each edge position of the convex shape is greater than zero. A length Y1 of the electrostatic resonance layer 90 on a straight line (passing through the center of the electrostatic resonance layer) parallel to the crystal direction [100] is greater than a length Y2 of the electrostatic resonance layer 90 on a straight line (passing through the center of the electrostatic resonance layer) parallel to the crystal direction [110]. It may be learned that the electrostatic resonance layer 90 shown in FIG. 31 is a circle with unequal radiuses.

It may be understood that, when a Young's modulus of the electrostatic resonance layer is different from the Young's modulus shown in FIG. 29, the electrostatic resonance layer may alternatively be a ring, and curvature of each position in an inner ring and an outer ring of the ring is greater than zero. Alternatively, the electrostatic resonance layer may be a convex shape, and curvature of each edge location of the convex shape is greater than zero. A shape of the electrostatic resonance layer may alternatively be different from the shapes shown in FIG. 30 and FIG. 31.

In conclusion, in the resonator provided in this embodiment of this application, a length of the electrostatic resonance layer on a straight line that is parallel to any target crystal direction and that passes through the center of the electrostatic resonance layer is negatively correlated with a Young's modulus of the electrostatic resonance layer in the any target crystal direction. It may be learned that, when a Young's modulus of the electrostatic resonance layer in a target crystal direction is large, in this application, a small length of the electrostatic resonance layer on a straight line that is parallel to the target crystal direction and that passes through the center of the electrostatic resonance layer is set. When a Young's modulus of the electrostatic resonance layer in a target crystal direction is small, in this application, a large length of the electrostatic resonance layer on a straight line that is parallel to the target crystal direction and that passes through the center of the electrostatic resonance layer is set. A stiffness of a portion of the electrostatic resonance layer in any target crystal direction at the center is positively correlated with a Young's modulus in the target crystal direction and a length of the electrostatic resonance layer on a straight line that is parallel to the target crystal direction and that passes through the center of the electrostatic resonance layer. Therefore, according to the "negative correlation" in this application, stiffnesses of portions of the electrostatic resonance layer in all the target crystal directions at the center can be uniform. When the electrostatic resonance layer vibrates, vibration amplitudes of the portions of the electrostatic resonance layer in all the target crystal directions at the center are uniform, and heat generated by these portions is uniform. This reduces a heat gradient, reduces a thermoelastic loss, and increases Q of the resonator.

If the electrostatic resonance layer shown in FIG. 30 is compared with an electrostatic resonance layer using a ring with an equal ring width, it may be found that, when the electrostatic resonance layer using the ring with the equal ring width vibrates, displacements of all positions differ greatly, thermal convection is large, and the thermoelastic loss is high; and when the electrostatic resonance layer shown in FIG. 30 vibrates, displacements of all positions are the same (or approximately the same), thermal convection is reduced, and the thermoelastic loss is reduced.

If the electrostatic resonance layer shown in FIG. 31 is compared with an electrostatic resonance layer using a circle with an equal radius, it may be found that, when the electrostatic resonance layer using the circle with the equal radius vibrates, displacements of all positions differ greatly, thermal convection is large, and the thermoelastic loss is high; and when the electrostatic resonance layer shown in FIG. 31 vibrates, displacements of all positions tend to be the same, thermal convection is reduced, and the thermoelastic loss is reduced.

Optionally, the length $c_\theta'$ of the electrostatic resonance layer on the straight line parallel to the any target crystal direction is correlated with $C_\theta$. For example, an absolute value of a difference between $C_\theta'$ and $C_\theta$ is less than or equal to $0.05 \times k \times C_0$ (for example, the difference between $c_\theta'$ and $C_\theta$ is zero). $\theta$ represents an included angle between the any target crystal direction and a reference direction;

$$C_\theta = \left( \frac{E_0}{E_\theta} \right)^k \times C_0$$

; $E_0$

represents a Young's modulus of the electrostatic resonance layer in a target crystal direction parallel to the reference direction; $E_\theta$ represents a Young's modulus of the electrostatic resonance layer in the any target crystal direction; $C_0$ represents a length of the electrostatic resonance layer on a straight line parallel to the reference direction; and k is a constant greater than zero. It may be

$$C_\theta = \left( \frac{E_0}{E_\theta} \right)^k \times C_0$$

learned from the equation that $C_\theta$ is negatively correlated with $E_\theta$, and $C_\theta'$ is close to $C_\theta$. Therefore, $C_\theta'$ is also negatively correlated with $E_\theta$.

It may be understood that $C_\theta$ may alternatively be calculated according to an equation different from the

$$C_\theta = \left( \frac{E_0}{E_\theta} \right)^k \times C_0$$

equation . For example,

$$C_\theta = \left( \frac{E_0}{E_\theta} \right)^k \times C_0 \times A$$

, where A is a coefficient.

In the foregoing embodiment, $E_0$ may be less than $E_\theta$. In other words, $E_0$ is a minimum value of the Young's moduli of the electrostatic resonance layer in all the target crystal directions. The target crystal direction parallel to the reference direction may be the foregoing crystal direction [100] or another target crystal direction. It may be understood that $E_0$ may alternatively not be a minimum value of the Young's moduli of the electrostatic resonance layer in all the target crystal directions. This is not limited in embodiments of this application.

Further, k in the foregoing equation is a constant greater than zero. A value of k is closely related to a thermoelastic loss of the electrostatic resonance layer. A proper value of k can further reduce the thermoelastic loss, further increase QTED, and increase Q of the resonator.

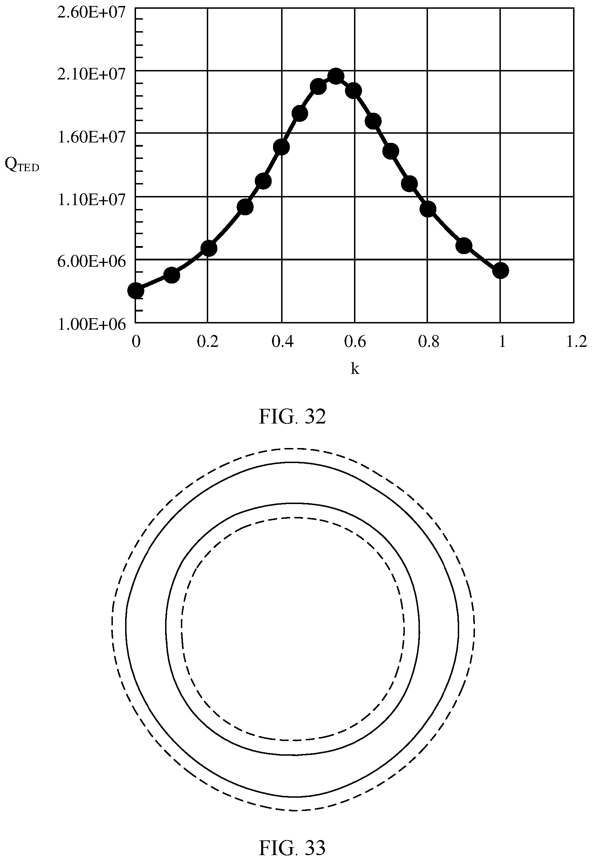

For example, when the electrostatic resonance layer is a ring, and curvature of each position in an inner ring and an outer ring of the ring is greater than zero, $0.3 \leq k \leq 0.8$. For example, k = 0.55. When the electrostatic resonance layer is a ring, and curvature of each position in an inner ring and an outer ring of the ring is greater than zero, a curve of a relationship between k and QTED may be shown in FIG. 32. In FIG. 32, a horizontal axis represents k, and a vertical axis represents QTED. In FIG. 32, 1.00E+0.6 indicates that 1.00 is multiplied by 10 to the power of 0.6, 6.00E+0.6 indicates that 6.00 is multiplied by 10 to the power of 0.6, and so on. It may be learned from FIG. 32 that, when k = 0.55, displacements of all positions pf the electrostatic resonance layer are uniform, and QTED reaches a peak value. The peak value is 6 times QTED of the electrostatic resonance layer using the ring with the equal ring width.

For another example, when the electrostatic resonance layer is a convex shape, and curvature of each position at an outer edge of the convex shape is greater than zero, $3 \leq k \leq 5$. For example, k = 4. When k = 4, the thermoelastic loss of the electrostatic resonance layer is the lowest, and QTED is the highest and is 13.6% higher than QTED of the electrostatic resonance layer using the ring with the equal ring width.

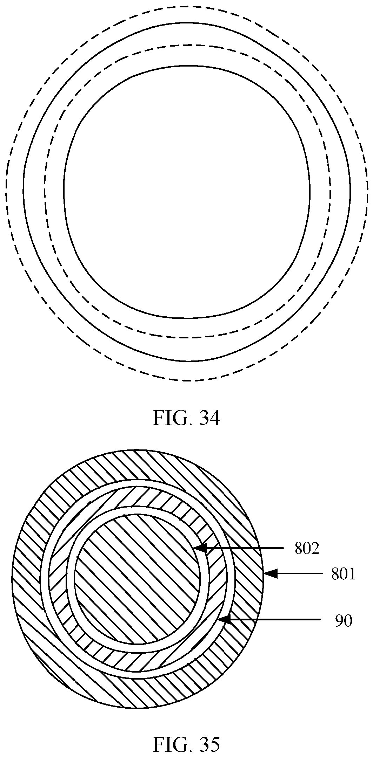

In addition, a vibration mode of the electrostatic resonance layer is not limited in embodiments of this application. The vibration mode may be a breathing mode, a lame mode, an SE mode, an LE mode, a WE mode, or the like. An order of the breathing mode is not limited in embodiments of this application either. A first-order breathing mode of the electrostatic resonance layer shown in FIG. 30 may be shown in FIG. 33. A second-order breathing mode of the electrostatic resonance layer may be shown in FIG. 34. A solid line figure represents a static state of the electrostatic resonance layer. A dashed line figure represents a vibration mode profile of the electrostatic resonance layer. In the first-order breathing mode, the inner ring and the outer ring of the electrostatic resonance layer stretch out or draw back at the same time. In the second-order breathing mode, the inner ring and the outer ring of the electrostatic resonance layer move in opposite directions, and the outer ring stretches out when the inner ring draws back. The first-order breathing mode may be used in a scenario in which a medium and low-frequency (approximately 10 megahertz) clock signal is output. The second-order breathing mode may be used in a scenario in which a high-frequency (approximately 200 megahertz) clock signal is output.

Further, the resonator includes an auxiliary electrode located at a same layer as the electrostatic resonance layer. Vibration of the electrostatic resonance layer may be driven by the auxiliary electrode, and the auxiliary electrode may also detect a vibration signal generated by vibration of the electrostatic resonance layer. The auxiliary electrode is spaced from the electrostatic resonance layer, and the auxiliary electrode and the electrostatic resonance layer have a same spacing in different target crystal directions of the electrostatic resonance layer. It may be understood that spacings in the different target crystal directions may alternatively be different. For example, in the different target crystal directions of the electrostatic resonance layer, an absolute value of a difference between the spacings between the auxiliary electrode and the electrostatic resonance layer is less than or equal to $0.05 \times k \times d$, $0.05 \times d$, or another value, k is a constant greater than zero, and d represents a spacing between the auxiliary electrode and the single crystal resonance part in the reference direction. Herein, k may be the same as k in the foregoing equation of $C_\theta$. A spacing between the auxiliary electrode and the electrostatic resonance layer in a target crystal direction of the electrostatic resonance layer is a length of a portion that is located between the auxiliary electrode and the electrostatic resonance layer and that is of a straight line passing through the center of the electrostatic resonance layer and parallel to the target crystal direction.

For example, a position relationship between the electrostatic resonance layer 90 shown in FIG. 30 and an auxiliary electrode 80 may be shown in FIG. 35. The resonator includes two auxiliary electrodes corresponding to the electrostatic resonance layer 90 in total, including an auxiliary electrode 801 and an auxiliary electrode 802. The auxiliary electrode 801 surrounds the electrostatic resonance layer 90, and the electrostatic resonance layer 90 surrounds the auxiliary electrode 802. The auxiliary electrode 801 is spaced from the electrostatic resonance layer 90, and the electrostatic resonance layer 90 is also spaced from the auxiliary electrode 802. In addition, in the different target crystal directions of the electrostatic resonance layer 90, spacings between the auxiliary electrode 801 and the electrostatic resonance layer 90 are the same; and in the different target crystal directions of the electrostatic resonance layer 90, spacings between the electrostatic resonance layer 90 and the auxiliary electrode 802 are the same. Optionally, in a same target crystal direction of the electrostatic resonance layer 90, a spacing between the auxiliary electrode 801 and the electrostatic resonance layer 90 is the same as a spacing between the electrostatic resonance layer 90 and the auxiliary electrode 802.

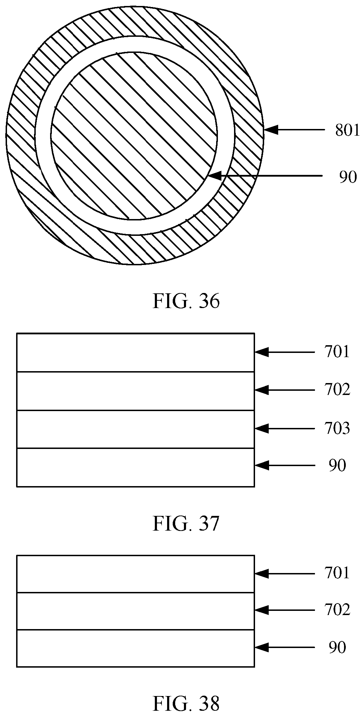

For another example, a position relationship between the electrostatic resonance layer 90 shown in FIG. 31 and an auxiliary electrode may be shown in FIG. 36. The resonator includes an auxiliary electrode 801 corresponding to the electrostatic resonance layer 90 in total. The auxiliary electrode 801 surrounds the electrostatic resonance layer 90. The auxiliary electrode 801 is spaced from the electrostatic resonance layer 90. In the different target crystal directions of the electrostatic resonance layer 90, spacings between the auxiliary electrode 801 and the electrostatic resonance layer 90 are the same.

It may be learned that, in this embodiment of this application, the auxiliary electrode and the electrostatic resonance layer are matched in shape, so that a spacing between the auxiliary electrode and the electrostatic resonance layer at each position remains at a specific value. In this way, when the electrostatic resonance layer is driven by the auxiliary electrode, strength of electric fields applied by the auxiliary electrode to all positions in the electrostatic resonance layer is consistent, so that vibration statuses at all the positions in the electrostatic resonance layer can be further consistent, and the thermoelastic loss is further reduced.

Further, regardless of whether the resonator includes the auxiliary electrode, the resonator may further include a piezoelectric resonance portion.

For example, FIG. 37 is a diagram of a cross section of an area in which the electrostatic resonance layer 90 in the resonator is located. As shown in FIG. 37, the resonator further includes a third electrode 701, a piezoelectric oscillator 702, and a fourth electrode 703.

The third electrode 701, the piezoelectric oscillator 702, the fourth electrode 703, and the electrostatic resonance layer 90 are sequentially stacked. In this case, the third electrode 701 and the fourth electrode 703 may be configured to drive the piezoelectric oscillator 702 to vibrate, and when the piezoelectric oscillator 702 vibrates, can drive the electrostatic resonance layer 90 to vibrate.

For another example, the electrostatic resonance layer is conductive, and the electrostatic resonance layer may be reused as the fourth electrode in FIG. 37. FIG. 38 is a diagram of a cross section of an area in which the electrostatic resonance layer 90 in the resonator is located. As shown in FIG. 38, the resonator further includes a third electrode 701 and a piezoelectric oscillator 702. The third electrode 701, the piezoelectric oscillator 702, and the electrostatic resonance layer 90 are sequentially stacked. In this case, the third electrode 701 and the electrostatic resonance layer 90 may be configured to drive the piezoelectric oscillator 702 to vibrate, and when the piezoelectric oscillator 702 vibrates, can drive the electrostatic resonance layer 90 to vibrate.

This application provides the resonator that includes "the coupling part, the piezoelectric resonance part, and the single crystal resonance part", and the resonator that has the "negative correlation" characteristic. The characteristic of the resonator that has the "negative correlation" characteristic may also be applied to the resonator that includes "the coupling part, the piezoelectric resonance part, and the single crystal resonance part".

For example, in the resonator that includes "the coupling part, the piezoelectric resonance part, and the single crystal resonance part", Young's moduli of the single crystal resonance part in different target crystal directions are different. The single crystal resonance part is layered. The target crystal direction is parallel to the single crystal resonance part. A length of the single crystal resonance part on a straight line parallel to any target crystal direction is negatively correlated with a Young's modulus of the single crystal resonance part in the any target crystal direction. The straight line passes through a center of the single crystal resonance part.

Optionally, an absolute value of a difference between $C_\theta'$ and $C_\theta$ is less than or equal to $0.05 \times k \times C_0$, where $C_\theta'$ represents the length of the single crystal resonance part on the straight line parallel to the any target crystal direction; $\theta$ represents an included angle between the any target crystal direction and a reference direction;

$$C_\theta = \left( \frac{E_0}{E_\theta} \right)^k \times C_0$$

; $E_0$ represents a Young's modulus of the single crystal resonance part in a target crystal direction parallel to the reference direction; $E_\theta$ represents the Young's modulus of the single crystal resonance part in the any target crystal direction; $C_0$ represents a length of the single crystal resonance part on a straight line parallel to the reference direction; and k is a constant greater than zero.

Optionally, $E_0$ is less than $E_\theta$.

Optionally, the single crystal resonance part is a ring, and curvature of each position in an inner ring and an outer ring of the ring is greater than zero; and $0.3 \leq k \leq 0.8$. For example, k = 0.55.

Optionally, the single crystal resonance part is a convex shape, and curvature of each position at an outer edge of the convex shape is greater than zero; and $3 \leq k \leq 5$. For example, k = 4.

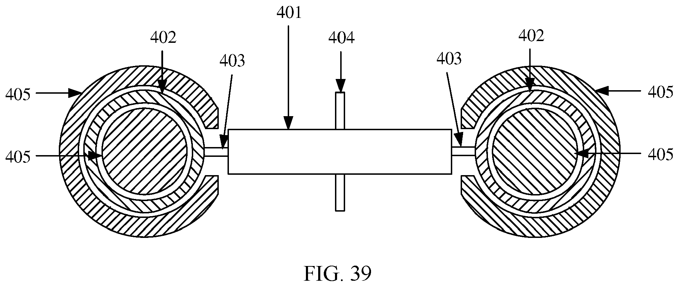

Optionally, the resonator further includes an auxiliary electrode corresponding to the single crystal resonance part, the auxiliary electrode and the single crystal resonance part are located at a same layer, and a gap exists between the auxiliary electrode and the single crystal resonance part. When the resonator includes the auxiliary electrode, in the different target crystal directions of the single crystal resonance part, spacings between the auxiliary electrode and the single crystal resonance part are the same. For example, when for a position relationship between the auxiliary electrode and the single crystal resonance part in FIG. 11, refer to the position relationship between the electrostatic resonance layer and the auxiliary electrode shown in FIG. 35, a structure of the resonator that includes the coupling part, the piezoelectric resonance part, and the single crystal resonance part may be shown in FIG. 39.

Optionally, the resonator may also include a piezoelectric resonance portion other than the piezoelectric resonance part. For example, the piezoelectric resonance portion may include a third electrode, a piezoelectric oscillator, and a fourth electrode, and the third electrode, the piezoelectric oscillator, the fourth electrode, and the single crystal resonance part are sequentially stacked. In this case, the third electrode and the fourth electrode may be configured to drive the piezoelectric oscillator to vibrate, and when the piezoelectric oscillator vibrates, can drive the single crystal resonance part to vibrate. For another example, the single crystal resonance part is conductive, and the single crystal resonance part can be reused as the foregoing fourth electrode. In this case, the resonator further includes a third electrode and a piezoelectric oscillator, and the third electrode, the piezoelectric oscillator, and the single crystal resonance part are sequentially stacked. In this case, the third electrode and the single crystal resonance part may be configured to drive the piezoelectric oscillator to vibrate, and when the piezoelectric oscillator vibrates, can drive the single crystal resonance part to vibrate.

The resonator in the resonant system provided in this embodiment of this application may be the resonator that includes "the coupling part, the piezoelectric resonance part, and the single crystal resonance part", or the resonator that has the "negative correlation" characteristic. The control circuit in the resonant system is configured to: provide a drive signal for the resonator through an electrode in the resonator, to drive the resonator to resonate and generate a vibration signal; and receive the vibration signal through an electrode in the resonator. The resonant system may be an oscillator, a sensor, or the like.

Both the first electrode group and the second electrode group in the signal obtaining method that is used for the control circuit in the resonant system and that is provided in this embodiment of this application may select proper electrodes according to corresponding resonators. When the resonator includes "the coupling part, the piezoelectric resonance part, and the single crystal resonance part", and the resonator has the "negative correlation" characteristic, for one electrode group of the first electrode group and the second electrode group, the electrode group may include at least two electrodes in the resonator, and these electrodes may be any electrode (including a resonance layer reused as an electrode, for example, the foregoing electrostatic resonance layer). The first electrode group and the second electrode group may be the same or may be different. This is not limited in embodiments of this application.

In this application, the terms "first", "second", and the like are merely intended for description, but cannot be understood as an indication or implication of relative importance. The term "at least one" refers to one or more, and the term "a plurality of" refers to two or more than two, unless expressly limited otherwise.

For different types of embodiments such as the resonator embodiment, the resonant system embodiment, and the signal obtaining method embodiment provided in embodiments of this application, refer to each other. This is not limited in embodiments of this application. A sequence of the steps of the method embodiments provided in the embodiments of this application can be properly adjusted, and the steps can be correspondingly added or deleted based on a situation. Any method that can be easily figured out by a person skilled in the art without departing from a technical scope disclosed in this application shall fall within the protection scope of this application, and therefore details are not described again.

In the corresponding embodiments provided in this application, it should be understood that the disclosed resonator, the disclosed resonant system, and the like may be implemented in other composition manners. For example, the embodiments described above are merely examples.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

**Claims**

1. A resonator, comprising: a piezoelectric resonance part, a single crystal resonance part, and a coupling part, wherein

   the piezoelectric resonance part comprises a first electrode, a piezoelectric layer, and a second electrode that are sequentially stacked, and a material of the single crystal resonance part is a single crystal material or a doped single crystal material;
   the piezoelectric resonance part and the single crystal resonance part are capable of resonating, and the piezoelectric resonance part and the single crystal resonance part are connected and coupled through the coupling part.

2. The resonator according to claim 1, wherein the resonator comprises two single crystal resonance parts and two coupling parts that are in one-to-one correspondence with the two single crystal resonance parts; and
   the two single crystal resonance parts are located on two opposite sides of the piezoelectric resonance part, and the piezoelectric resonance part and the single crystal resonance parts are connected and coupled through the coupling parts corresponding to the single crystal resonance parts.

3. The resonator according to claim 1 or 2, wherein the doped single crystal material comprises single crystal silicon whose doping concentration is greater than or equal to the $19^{th}$ power of 10.

4. The resonator according to any one of claims 1 to 3, wherein a vibration mode of the single crystal resonance part is a breathing mode, or a lame mode, or a square extensional, SE, mode, or a length extensional, LE, mode, or a width extensional, WE, mode.

5. The resonator according to any one of claims 1 to 4, an orthographic projection of the single crystal resonance part on a reference plane parallel to the piezoelectric layer is any one of the following cases:

   the orthographic projection is a ring having a plurality of curvature radiuses in an outer ring, and a curvature radius of each position in the outer ring is negatively correlated with a ring width of the position;
   the orthographic projection is a ring having one curvature radius in an outer ring and having a curvature radius in an inner ring;
   the orthographic projection is a circle;
   the orthographic projection is an ellipse; and,
   the orthographic projection is a square.

6. The resonator according to any one of claims 1 to 5, wherein Young's moduli of the single crystal resonance part in different target crystal directions are different, the single crystal resonance part is layered, and the target crystal direction is parallel to the single crystal resonance part; and
a length of the single crystal resonance part on a straight line parallel to any target crystal direction is negatively correlated with a Young's modulus of the single crystal resonance part in the any target crystal direction, and the straight line passes through a center of the single crystal resonance part.

7. The resonator according to claim 6, wherein an absolute value of a difference between $C_\theta'$ and $C_\theta$ is less than or equal to $0.05 \times k \times C_0$, wherein

$C_\theta'$ represents the length of the single crystal resonance part on the straight line parallel to the any target crystal direction;
$\theta$ represents an included angle between the any target crystal direction and a reference direction;

$$C_\theta = \left(\frac{E_0}{E_\theta}\right)^k \times C_0 ;$$

$E_0$ represents a Young's modulus of the single crystal resonance part in a target crystal direction parallel to the reference direction;
$E_\theta$ represents the Young's modulus of the single crystal resonance part in the any target crystal direction;
$C_0$ represents a length of the single crystal resonance part on a straight line parallel to the reference direction; and
k is a constant greater than zero.

8. The resonator according to claim 7, wherein $E_0$ is less than $E_\theta$.

9. The resonator according to claim 7 or 8, wherein the single crystal resonance part is a ring, and curvature of each position in an inner ring and an outer ring of the ring is greater than zero; and $0.3 \le k \le 0.8$.

10. The resonator according to claim 9, wherein k = 0.55.

11. The resonator according to claim 7 or 8, wherein the single crystal resonance part is a convex shape, and curvature of each position at an outer edge of the convex shape is greater than zero; and $3 \le k \le 5$.

12. The resonator according to claim 11, wherein k = 4.

13. The resonator according to any one of claims 1 to 12, wherein a vibration mode of the piezoelectric resonance part is an LE mode or a WE mode.

14. The resonator according to any one of claims 1 to 13, wherein a material of the piezoelectric resonance part comprises a single crystal material or a doped single crystal material.

15. The resonator according to claim 14, wherein a material of the first electrode comprises a single crystal material or a doped single crystal material.

16. The resonator according to any one of claims 1 to 15, wherein a thickness of the first electrode, a thickness of the piezoelectric layer, and a thickness of the second electrode are in a descending order.

17. The resonator according to any one of claims 1 to 16, wherein a material of the coupling part comprises a single crystal material or a doped single crystal material.

18. The resonator according to any one of claims 1 to 17, wherein the coupling part is connected to the first electrode.

19. The resonator according to claim 18, wherein the first electrode, the coupling part, and the single crystal resonance part are made of a same material and have a same thickness.

20. The resonator according to any one of claims 1 to 19, wherein both a first orthographic projection of the piezoelectric resonance part on the reference plane parallel to the piezoelectric layer and a second orthographic projection of the coupling part on the reference plane are strips, and a third orthographic projection of the single crystal resonance part on the reference plane is a ring; and
a width of the first orthographic projection, a ring width of the third orthographic projection, and a width of the second orthographic projection are in a descending order.

21. The resonator according to any one of claims 1 to 20, wherein the orthographic projection of the piezoelectric resonance part on the reference plane parallel to the piezoelectric layer is located outside the orthographic projection of the single crystal resonance part on the reference plane.

22. The resonator according to any one of claims 1 to 21, wherein the resonator further comprises an anchoring part; and
the anchoring part is connected to a vibration node of the piezoelectric resonance part, and is spaced from the single crystal resonance part, and the anchoring part is configured to anchor a portion of the resonator other than the anchoring part.

23. The resonator according to claim 22, wherein a first arrangement direction of the piezoelectric resonance part and the single crystal resonance part is different from a second arrangement direction of the piezoelectric resonance part and the anchoring part, and both the first arrangement direction and the second arrangement direction are parallel to the piezoelectric layer.

24. The resonator according to any one of claims 1 to 23, wherein the resonator further comprises an auxiliary electrode corresponding to the single crystal resonance part, the auxiliary electrode and the single crystal resonance part are located at a same layer, and a gap exists between the auxiliary electrode and the single crystal resonance part.

25. The resonator according to claim 24, wherein the auxiliary electrode and the single crystal resonance part have a same spacing in different target crystal directions of the single crystal resonance part.

26. The resonator according to any one of claims 1 to 25, wherein the resonator further comprises a third electrode, a piezoelectric resonance layer, and a fourth electrode, and the third electrode, the piezoelectric oscillator, the fourth electrode, and the single crystal resonance part are sequentially stacked; or the single crystal resonance part is conductive, the resonator further comprises a third electrode and a piezoelectric oscillator, and the third electrode, the piezoelectric oscillator, and the single crystal resonance part are sequentially stacked.

27. The resonator according to any one of claims 22 to 26, wherein the resonator further comprises the anchoring part, the anchoring part is connected to the vibration node of the piezoelectric resonance part, and are spaced from the single crystal resonance part, and the anchoring part is configured to anchor the portion of the resonator other than the anchoring part; and an orthographic projection of the resonator on the reference plane parallel to the piezoelectric layer is an axial symmetric figure, and the axial symmetric figure has a first symmetry axis that passes through an orthographic projection of the anchoring part on the reference plane.

28. The resonator according to any one of claims 1 to 27, wherein the orthographic projection of the resonator on the reference plane parallel to the piezoelectric layer is the axial symmetric figure, and the axial symmetric figure has a second symmetry axis that passes through the orthographic projection of the single crystal resonance part on the reference plane.

29. The resonator according to claim 28, wherein an extension direction of the second symmetry axis is a crystal direction [100] of the single crystal resonance part, the extension direction is a crystal direction [110] of the single crystal resonance part, or the extension direction is between the crystal direction [100] and the crystal direction [110].

30. A resonator, comprising: an electrostatic resonance layer, wherein

Young's moduli of the electrostatic resonance layer in different target crystal directions are different, and the target crystal direction is parallel to the electrostatic resonance layer; and a length of the electrostatic resonance layer on a straight line parallel to any target crystal direction is negatively correlated with a Young's modulus of the electrostatic resonance layer in the any target crystal direction, and the straight line passes through a center of the electrostatic resonance layer.

31. The resonator according to claim 30, wherein an absolute value of a difference between $C_\theta{}'$ and $C_\theta$ is less than or equal to $0.05 \times k \times C_0$, wherein

$C_\theta{}'$ represents the length of the electrostatic resonance layer on the straight line parallel to the any target crystal direction;
$\theta$ represents an included angle between the any target crystal direction and a reference direction;

$$C_\theta = \left(\frac{E_0}{E_\theta}\right)^k \times C_0 \; ;$$

$E_0$ represents a Young's modulus of the electrostatic resonance layer in a target crystal direction parallel to the reference direction;
$E_\theta$ represents the Young's modulus of the electrostatic resonance layer in the any target crystal direction;
$C_0$ represents a length of the electrostatic resonance layer on a straight line parallel to the reference direction; and
k is a constant greater than zero.

32. The resonator according to claim 31, wherein $E_0$ is less than $E_\theta$ .

33. The resonator according to claim 31 or 32, wherein the electrostatic resonance layer is a ring, and curvature of each position in an inner ring and an outer ring of the ring is greater than zero; and $0.3 \leq k \leq 0.8$.

34. The resonator according to claim 33, wherein k = 0.55.

**35.** The resonator according to claim 31 or 32, wherein the electrostatic resonance layer is a convex shape, and curvature of each position at an outer edge of the convex shape is greater than zero; and $3 \le k \le 5$.

**36.** The resonator according to claim 35, wherein k = 4.

**37.** The resonator according to any one of claims 30 to 36, wherein the resonator comprises an auxiliary electrode located at a same layer as the electrostatic resonance layer; and
the auxiliary electrode is spaced from the electrostatic resonance layer, and the auxiliary electrode and the electrostatic resonance layer have a same spacing in different target crystal directions of the electrostatic resonance layer.

**38.** The resonator according to any one of claims 30 to 37, wherein the resonator further comprises a first electrode, a piezoelectric resonance layer, and a second electrode, and the first electrode, the piezoelectric resonance layer, the second electrode, and the electrostatic resonance layer are sequentially stacked; or
the electrostatic resonance layer is conductive, the resonator further comprises a first electrode and a piezoelectric resonance layer, and the first electrode, the piezoelectric resonance layer, and the electrostatic resonance layer are sequentially stacked.

**39.** A resonant system, comprising: the resonator according to any one of claims 1 to 38 and a control circuit, wherein
the control circuit is configured to: provide a drive signal for the resonator through an electrode in the resonator, to drive the resonator to resonate and generate a vibration signal; and receive the vibration signal through an electrode in the resonator.

**40.** The resonant system according to claim 39, wherein the resonant system is an oscillator or a sensor.

Phase noise

$\sim R_m/Q^2$

$\sim R_m^2$

Offset frequency

FIG. 1

$\Delta f$

TCF turnover point

Temperature

FIG. 2

| 03 |
|----|
| 02 |
| 01 |

FIG. 3

FIG. 4

401

4013  4012  4011

402    402         H3    402         402

H2

H1

403         403

FIG. 5

402    401    402

403    404    403

404

FIG. 6

402          401          404          403          402

403

FIG. 7

402          401          404          403          402

403

Position 1

Position 2

404

FIG. 8

FIG. 9

FIG. 10

402    401
405         403    404    403    402    405

B                                              B

FIG. 11

401

4013  4012  4011

402   405   402              402   405   402

403              403

FIG. 12

FIG. 13

[110]

[100]

FIG. 14

[110]

[100]

FIG. 15

FIG. 16

FIG. 17

FIG. 18

FIG. 19

FIG. 20

FIG. 21

Target material layer

FIG. 22

401

4013 4012 4011

402    405    402    4013 4012 4011    402    405    402

403    403

4062    4062    4061

406

FIG. 23

Target material layer

4062    4062    4061

406

FIG. 24

Control circuit — 1302

4013  4012  4011

— 1301

FIG. 25

Control circuit — 1302

4013  4012  4011

405                    405

— 1301

FIG. 26

Resonator
1301

Holding
circuit
13021

Clock signal

FIG. 27

S501: A control circuit provides a drive signal for a resonator through a connected first electrode group in the resonator, to drive the resonator to resonate and generate a vibration signal

S502: The control circuit receives the vibration signal through a connected second electrode group in the resonator

FIG. 28

90°

75°

60°

[100]

45°

Young's modulus

30°

15°

0°

[110]

Young's modulus

FIG. 29

90

FIG. 30

90

FIG. 31

FIG. 32

FIG. 33

FIG. 34

FIG. 35

FIG. 36

FIG. 37

FIG. 38

FIG. 39

# EP 4 478 610 A1

| | INTERNATIONAL SEARCH REPORT | International application No. |
|---|---|---|
| | | **PCT/CN2023/085912** |

**A. CLASSIFICATION OF SUBJECT MATTER**

H03H9/205(2006.01)i; H03H9/02(2006.01)i

According to International Patent Classification (IPC) or to both national classification and IPC

**B. FIELDS SEARCHED**

Minimum documentation searched (classification system followed by classification symbols)

IPC: H03H

Documentation searched other than minimum documentation to the extent that such documents are included in the fields searched

Electronic data base consulted during the international search (name of data base and, where practicable, search terms used)

CNTXT, WPI, VEN, WPABSC, ENTXTC, CNKI: 谐振, 压电, 单晶, 耦合部, 锚, 热, 损耗, 弹性, 杨氏模量, 环, 圆, 椭圆, resonator, piezoelectric, crystal, coupling, anchor, heat, young+, modulus

**C. DOCUMENTS CONSIDERED TO BE RELEVANT**

| Category* | Citation of document, with indication, where appropriate, of the relevant passages | Relevant to claim No. |
|---|---|---|
| X | US 2012038431 A1 (TEKNOLOGIAN TUTKIMUSKESKUS VTT;) 16 February 2012 (2012-02-16) <br> description, paragraphs [0013]-[0140], and figures 1a-13b | 1-29, 39-40 |
| X | CN 106876575 A (SEIKO EPSON CORP.) 20 June 2017 (2017-06-20) <br> description, paragraphs [0026]-[0109], and figures 1-21 | 30-40 |
| A | JP 2012237673 A (DAINIPPON PRINTING CO., LTD.) 06 December 2012 (2012-12-06) <br> entire document | 1-40 |
| A | CN 113037245 A (TIANJIN UNIVERSITY) 25 June 2021 (2021-06-25) <br> entire document | 1-40 |
| A | CN 106549649 A (SHANGHAI INSTITUTE OF MICROSYSTEM AND INFORMATION TECHNOLOGY, CHINESE ACADEMY OF SCIENCES) 29 March 2017 (2017-03-29) <br> entire document | 1-40 |

☐ Further documents are listed in the continuation of Box C.    ☑ See patent family annex.

| | |
|---|---|
| \* Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **20 June 2023** | **23 June 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/085912**

| Patent document cited in search report | | | Publication date (day/month/year) | Patent family member(s) | | | Publication date (day/month/year) |
|---|---|---|---|---|---|---|---|
| US | 2012038431 | A1 | 16 February 2012 | WO | 2012020173 | A1 | 16 February 2012 |
| | | | | US | 8786166 | B2 | 22 July 2014 |
| | | | | EP | 2603975 | A1 | 19 June 2013 |
| | | | | EP | 2603975 | A4 | 21 August 2013 |
| | | | | EP | 2603975 | B1 | 17 December 2014 |
| | | | | FI | 20105849 | A0 | 13 August 2010 |
| | | | | FI | 20105849 | A | 14 February 2012 |
| | | | | FI | 20105849 | L | 15 September 2014 |
| CN | 106876575 | A | 20 June 2017 | JP | 2017092097 | A | 25 May 2017 |
| | | | | US | 2017119351 | A1 | 04 May 2017 |
| | | | | US | 10849596 | B2 | 01 December 2020 |
| JP | 2012237673 | A | 06 December 2012 | JP | 5708222 | B2 | 30 April 2015 |
| CN | 113037245 | A | 25 June 2021 | WO | 2022188100 | A1 | 15 September 2022 |
| | | | | CN | 113037245 | B | 03 February 2023 |
| CN | 106549649 | A | 29 March 2017 | CN | 106549649 | B | 19 July 2019 |

Form PCT/ISA/210 (patent family annex) (July 2022)

**REFERENCES CITED IN THE DESCRIPTION**

**Patent documents cited in the description**

- CN 202210347533